# EUROPÄISCHE PATENTSCHRIFT

(11) **EP 0 828 580 B1**
(45) Veröffentlichungstag und Bekanntmachung des Hinweises auf die Patenterteilung: **14.11.2001**
(21) Anmeldenummer: 96915960.7
(22) Anmeldetag: 24.05.1996
(51) Int. Cl.: B23K 1/015, B23K 1/08

(54) **VERFAHREN UND VORRICHTUNG ZUM WELLEN- UND/ODER DAMPFPHASENLÖTEN ELEKTRONISCHER BAUGRUPPEN**
PROCESS AND DEVICE FOR THE WAVE OR VAPOUR-PHASE SOLDERING OF ELECTRONIC UNITS
PROCEDE ET DISPOSITIF PERMETTANT DE BRASER A LA VAGUE ET/OU EN PHASE VAPEUR DES COMPOSANTS ELECTRONIQUES

(30) Priorität: 24.05.1995 DE 19519188
(43) Veröffentlichungstag der Anmeldung: 18.03.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHEEL, Wolfgang, D-10178 Berlin (DE); RING, Karl, D-82275 Emmering (DE); HAFNER, Willi, CH-4710 Balsthal (CH); LEICHT, Helmut, D-86343 Königsbrunn (DE)
(86) Internationale Anmeldenummer: DE9600968
(87) Internationale Veröffentlichungsnummer: WO9637330

(56) Entgegenhaltungen:
- EP-A- 0 211 563
- EP-A- 0 239 381
- DE-C- 4 024 181
- FR-A- 2 537 912
- FR-A- 2 556 110
- US-A- 4 194 297
- US-A- 5 146 694

## Beschreibung

### Technisches Gebiet

Die Erfindung betrifft ein Verfahren und eine Vorrichtung zum Wellen- und/oder Dampfphasenlöten elektronischer Baugruppen.

Die Erfindung ist verwendbar in der Fertigung elektronischer Baugruppen, in der heutzutage herkömmliche Bauelemente in Durchstecktechnik sowie oberflächenmontierbare Bauelemente (SMD: Surface-Mount-Device) gelötet werden müssen. Ein weiteres Anwendungsgebiet der Erfindung ist das Weichlöten metallischer Halbzeuge.

### Stand der Technik

Zum Löten oberflächenmontierbarer Bauelemente werden bekanntermaßen Reflow-Lötverfahren (Reflowlöten) eingesetzt. Bei diesen Verfahren wird das Lot in Form von Lotpaste durch Energieeintrag auf- und umgeschmolzen und die gewünschten Lotverbindungen hergestellt. Als Energieträger bei bekannten Reflow-Lötverfahren werden Infrarotstrahlung (Infrarotlöten) oder Heißgas (Konvektionslöten), insbesondere auch Stickstoff, oder Laserstrahlung (Laserlöten) oder gesättigter Dampf wie beim Dampfphasenlöten verwendet. Die heutzutage verbreitetsten sind das Infrarotlöten, das Konvektionslöten und das Dampfphasenlöten. Während das Infrarotlöten vornehmlich bei Baugruppen mittlerer Komplexität, geringer Produktvielfalt und hohen Stückzahlen eingesetzt wird, eignet sich das Dampfphasenlöten besonders gut für hohen Durchsatz bzw. hohe Stückzahlen bei kleinen Rasterabständen und hohen Packungsdichten und wird deshalb in der SMD-Technik verwendet. Mit der Entwicklung neuer Dampfphasenlötverfahren ohne Fluorkohlenwasserstoffe als Sekundärmedium haben diese Lötverfahren auch angesichts noch komplexerer SMD-Baugruppen unter den Reflow-Lötverfahren die größte Bedeutung erlangt.

Klassische Dampfphasenlötverfahren sind etwa in der DE 35 18 444, der EP 0 349 094 und der Schrift Produktronik, 1/2, 1993, Seiten 28 bis 32, "Dampfphasenlötanlagen in neuer Technik, Zum Leben erweckt" von H. Beine beschrieben, bei denen die zu erwärmenden Produkte bzw. Baugruppen vollständig in den Dampfbereich eingefahren und vollständig auf die Siedetemperatur des verwendeten Mediums erwärmt werden. Vergleiche dazu insbesondere die Prinzipskizze in Bild 2 der zuletzt genannten Schrift, bei der die Dampfgrenze über das zu lötende Produkt steigt, sobald sich das Lotgut auf die Siedetemperatur des verwendeten Mediums erwärmt hat. Beim Dampfphasenlöten wird beim Kondensieren einer gesättigten Dampfphase auf den Oberflächen des Lotgutes Energie in Form von Wärme frei. Durch die freiwerdende Kondensationswärme schmilzt das Lot auf, benetzt die Fügeteile und realisiert eine stoffschlüssige Verbindung zwischen Bauelementeanschluß und zugeordneter Anschlußkonfiguration auf dem Baugruppenträger. Dabei bestimmt die Kondensatfilmdicke am bzw. auf dem Fügeteil über den Wärmeübergangswiderstand die Lötzeit. Das Kondensat des Dampfes wirkt außerdem als Reinigungsmittel, da es Schmutz und sonstige Ablagerungen von den Bauelemente(anschlüssen) abspült. Die gesättigte Dampfphase wird durch eine siedende Primärflüssigkeit erzeugt. Damit bestimmt der Siedepunkt der Primärflüssigkeit die Arbeitstemperatur des Lötprozesses, die verfahrensbezogen konstant ist. Eine lokale thermische Überbelastung der Bauelemente ist im Prinzip dadurch ausschließbar, daß die Bauelemente mindestens bis zur Löttemperatur wärmestabil sind. Die Auswahl einer Primärflüssigkeit in Abstufung der Siedetemperatur dient der Verarbeitung unterschiedlicher Lotwerkstoffe.

Das Dampfphasenlötverfahren zeichnet sich durch eine genau definierte Löt-bzw. Arbeitstemperatur, eine inerte Atmosphäre, eine gleichmäßige Erwärmung des Lotgutes aus und ist besonders zur Verarbeitung von Bauelementen mit sehr unterschiedlichen Wärmekapazitäten geeignet.

Nachteilig ist, daß z. B. neben SMD-Bauteilen (insbesondere auch SMD-Tantalkondensatoren) nicht auch Bauelemente in Durchstecktechnik mit vertretbarem Aufwand gelötet werden können. Es ist zudem keine selektive Erwärmung möglich, d. h. alle Einzelkomponenten müssen bis zur Löttemperatur temperaturstabil sein, was entweder eine Einschränkung hinsichtlich der Löttemperatur und der Lotwerkstoffe bedeutet oder eine Nachbestückung der nicht temperaturstabilen Bauelemente erforderlich macht. Dies betrifft in erster Linie Elektrolytkondensatoren, welche in der Regel für Betriebstemperaturen bis ca. 100° C ausgelegt sind, bei Temperaturen darüber hinaus jedoch ausgasen und zerstört werden. In zweiter Linie gehören dazu Bauteile, welche nichttemperaturbeständige Kunststoffe enthalten, wie etwa Stecker und Schalter.

Ein weiterer Nachteil liegt darin, daß Löttemperaturen gewählt werden müssen, die ca. 50° C über der Schmelztemperatur, z. B. 183° C von eutektischem Blei-Zinn-Lot, liegen, damit eine möglichst gute Lotbenetzung und Lotausbreitung erreicht wird.

Zum Löten von Bauelementen, insbesondere in Durchstecktechnik, ist das Wellen-Lötverfahren (kurz: Wellenlöten) allseits bekannt. Dabei wird ein Baugruppenträger, welcher die Bauelemente auf seiner Oberseite trägt, mit seiner Unterseite in Kontakt mit flüssigem Lotmaterial gebracht, wodurch die durch den Baugruppenträger durchgesteckten Anschlußbeinchen von Bauelementen mit Lot benetzen und beim Entfernen vom Lotmaterial sich eine Lotverbindung ausbildet. Das Lotmaterial wird insbesondere in Form einer Lotwelle bereitgestellt, bei der das Lot aus einem Lotbad herausgepumpt wird, einen Bogen beschreibt, anschließend wieder aufgefangen und gegebenenfalls von Verunreinigungen gereinigt und wieder dem Lotbad zugeführt wird. Dabei sind elektrodynamische Lotpumpen mechanischen Lotpumpen weit überlegen.

Wellenlötverfahren zum Löten von elektronischen Baugruppen mit eutektischem Blei-Zinn-Lot (Schmelztemperatur 183 °C) arbeiten abhängig vom verwendeten Flußmittel beispielsweise mit einer Vorwärmtemperatur von ca. 110° C bis 130°C auf der Bauelementeseite bzw. Baugruppenträgeroberseite, was zu Temperaturen auf der dazu entgegengesetzten Seite des Baugruppenträgers von maximal etwa 160° C bis 180° C führt. Die zum Erreichen einer Löttemperatur auf der Bauelementeseite von ca. 200° C bis 210° C zusätzlich notwendige Energie wird durch die Lotwelle von der Baugruppenträgerunterseite zugeführt. Die Lotwellentemperatur der Lotwelle wird dazu ca. 50° C höher als die Löttemperatur eingestellt. Üblich sind Lotwellentemperaturen zwischen ca. 245° C und 260° C. Generell ist bei bekannten Wellenlötverfahren die Lotwellentemperatur bis ca. 270° C einstellbar. Für die Lötwärmebeständigkeit von Leiterplatten ist im amerikanischen Standard J-STD-001 eine Temperatur von maximal 288 ° C angegeben.

Nachteilig bei den bekannten Wellenlötverfahren ist, daß sie meist in Umgebungsatmosphäre arbeiten und demzufolge sich beim Ablösen der Lotwelle von der Unterseite eines Baugruppenträgers Brücken und Zapfen bilden, die das Löten nur bis zu einem Rastermaß von ca. 0,5 mm zulassen. Zudem muß die Lotwelle eine um ca. 50° C höhere Temperatur als die Löttemperatur haben, damit nach dem Energietransfer von der Lotwelle über die Unterseite eines Baugruppenträgers auf dessen Oberseite dort die Löttemperatur sicher erreicht wird. Die Probleme mit den temperaturempfindlichen Bauelementen und der Zwang zur aufwendigen Nachbestückung solcher Bauelemente treffen auch hier zu. Zudem ergeben sich weitere Einschränkungen bei der Verwendung bleifreier Lote, deren Schmelztemperaturen deutlich über der Schmelztemperatur des gegenwärtig häufig verwendeten eutektischen Blei-Zinn-Lotes von 183° C liegen. Des weiteren wird zur Abdeckung des Lotbades oftmals entweder Öl oder Stickstoff verwendet.

Aus der DE-AS 24 42 180 ist ein Verfahren und eine Vorrichtung zum Löten elektronischer Baugruppen bekannt. Insbesondere ist in Fig. 3 dieser Druckschrift ein Verfahren, das für das Wellenlöten geeignet ist, offenbart, bei dem mit Bauelementen bestückte Leiterplatten durch einen Behälter transportiert werden. In dem Behälter ist in bekannter Weise eine Lotwelle bzw. -fontäne ausgebildet. Zusätzlich enthält der Behälter eine Primärflüssigkeit, die mit Heizelementen bis zum Siedepunkt erhitzt wird und verdampft. Der gesättigte Dampf erfüllt den gesamten Behälter und wird am Eintritts- und am Austrittskanal des Behälters, die zum Ein- und Ausführen von Baugruppen dienen, mittels Kühleinrichtungen am Austritt aus dem Behälter gehindert, wobei mit letzterem Primärflüssigkeitsverluste minimiert werden. Die Welle aus geschmolzenem Lötmaterial wird bei diesem Verfahren auf einer Temperatur gehalten, die über der Siedetemperatur der Primärflüssigkeit liegt, die wiederum über dem Schmelzpunkt des Lötmittels liegt.

Die im Wellenlötverfahren zu lötenden Bauelemente gelangen bei Raumtemperatur durch den Eintrittskanal in den Behälter. Sie werden durch die latente Verdampfungswärme des heißen gesättigten Dampfes, der auf ihnen kondensiert auf eine über dem Schmelzpunkt des Lötmittels liegende Temperatur vorerwärmt. Durch diese Vorerwärmung schmilzt jede Lötmittelschicht auf den Bauelementen und bewirkt somit das Lötmittelschmelzen. Die Bauelemente treten in vorgewärmtem Zustand in die Welle des geschmolzenen Lötmittels ein und werden darin gelötet. Die Lotwelle dient nicht zum Erwärmen der Bauelemente sondern nur zum Aufbringen des Lötmittels. Dadurch sind Wärmezufuhr und Lötmittelzufuhr zwei getrennte gut kontrollierbare Arbeitsprozesse. Wenn die Bauelemente die Welle verlassen, bleibt das auf den Bauelementen befindliche Lötmaterial einschließlich des durch die Welle aufgebrachten Lötmittels geschmolzen, so daß aufgrund des Fließens des Lötmaterials infolge der Oberflächenspannung Lötfehler vermindert werden. Erst nach dem Austrittskanal erfolgt zufolge der Abkühlung bis auf Raumtemperatur die Erstarrung des Lötmittels.

In einer weiteren Ausführungsform des bekannten Verfahrens wird eine Primärflüssigkeit mit einem Siedepunkt unterhalb des Schmelzpunktes des Lötmittels gewählt. Damit wird ein Bauelement allein durch den gesättigten Dampf vorerwärmt und die restliche Energie zum Erreichen der Löttemperatur sowie das Lötmaterial durch die Lotwelle geliefert.

Von Nachteil bei der in DE-AS 24 42 180 beschriebenen Erfindung ist, daß temperaturempfindliche Bauelemente zufolge der Nichtselektivität des Lötverfahrens nachbestückt werden müssen. Dies ist besonders nachteilig in der Massenproduktion, da zusätzliche Verfahrensschritte erforderlich sind und die selektive Nachbestückung von Einzelbauelementen aufwendig und oft nicht mit der erforderlichen Qualität durchführbar ist.
In US-A-4 194 297 wird ein Verfahren bzw. eine Vorrichtung gemäß dem oberbegriff des Anspruchs 1 bzw. 18 beschrieben.

### Darstellung der Erfindung

Ausgehend von dem oben dargelegten Stand der Technik ist es Aufgabe der vorliegenden Erfindung ein Verfahren und eine Vorrichtung zum Löten elektronischer Baugruppen derart weiterzubilden, daß neben bleihaltigen Loten auch bleifreie Lote verwendbar sind, daß ferner herkömmliche Standardbaugruppen gelötet werden können, die in der Regel mit bauelementeseitig zu lötenden Bauelementen z. B. Surface-Mount-Devices (SMD), und mit Bauelementen, deren Anschlußbeinchen durch den Baugruppenträger durchgesteckt sind, bestückt sind, und daß weiterhin wärmeempfindliche Bauelemente, z. B. Elektrolytkondensatoren, während des Lötprozesses nicht geschädigt oder zerstört werden, und daß eine Massenproduktion bei hoher Qualität der Lotverbindungen realisierbar ist.

Eine erfindungsgemäße Lösung dieser Aufgabe besteht in einem Verfahren zum Löten elektronischer Baugruppen gemäß den kennzeichnenden Merkmalen des Anspruchs 1 sowie einer Vorrichtung zum Löten elektronischer Baugruppen nach Anspruch 18. Bevorzugte Weiterbildungen sind in den Unteransprüchen aufgeführt.

Bei einem erfindungsgemäßen Verfahren zum Löten elektronischer Baugrupunter Verwendung des Dampfphasenlötens oder einer Kombination aus Wellenlöten und Dampfphasenlöten, wobei das Wellenlöten und das Dampfphasenlöten in einer einzigen Kammer durchgeführt werden, wird eine elektronische Baugruppe derart plaziert und/oder der vom gesättigten Dampf einer Primärflüssigkeit erfüllte Volumenanteil der Kammer so reguliert, daß sich wärmeempfindliche Bauelemente der Baugruppe höchstens teilweise im gesättigten Dampf befinden, und daß die zu lötenden Anschlüsse der elektronischen Bauelemente der Baugruppe sich während des Lötens im gesättigten Dampf befinden. Durch geeignete Plazierung einer Baugruppe und/oder der Regulierung des vom gesättigten Dampfes ausgefüllten Kammerteilvolumens wird sichergestellt, daß wärmeempfindliche Bauelemente nicht völlig vom gesättigten Dampf umgeben sind.

Wärmeempfindliche Bauelemente werden dabei anhand ihrer Lötwärmebeständigkeit, die vom Bauelementetyp abhängt, und der maximal zulässigen Umgebungstemperatur unterschieden. Als Bauelementetypen sind insbesondere die bedrahteten Bauelemente und die oberflächenmontierten Bauelemente (SMD = Surface Mount Device) von Wichtigkeit.

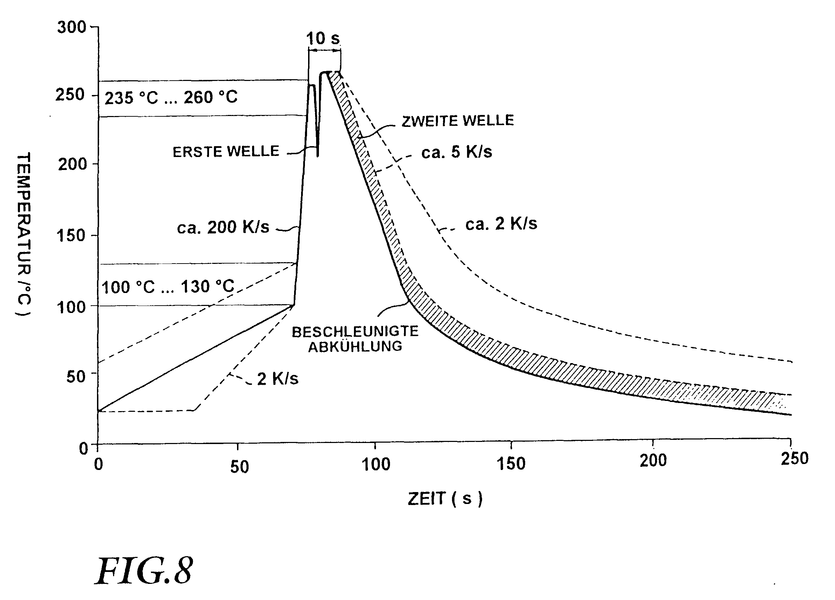

Bedrahtete Bauelemente haben meistens eine Lötwärmebeständigkeit nach DIN IEC 68 Teil 2-20. Bei den dort angegebenen Testmethoden werden nur die zu lötenden Anschlußdrähte eines Bauelementes in ein Lotbad von 260°C oder 350°C (siehe Fig. 8) mit einer definierten Verweilzeit (z. B. 5 Sekunden) getaucht, nicht jedoch das gesamte Bauelement. Die Bauelemente dürfen nach diesem Test ihre elektrischen und mechanischen Eigenschaften nicht ändern. Im Gegensatz zur Lötwärmebeständigkeit bezüglich der zu lötenden Anschlußdrähte dürfen bedrahtete Bauelemente als Ganzes, wie z. B. Elektrolytkondensatoren, nur einer bestimmten Dauertemperaturbelastung ausgesetzt sein.

Abhängig vom jeweiligen Typ beträgt die maximale Umgebungstemperatur für einen bedrahteten Elektrolytkondensator etwa 85°C bis 125°C.

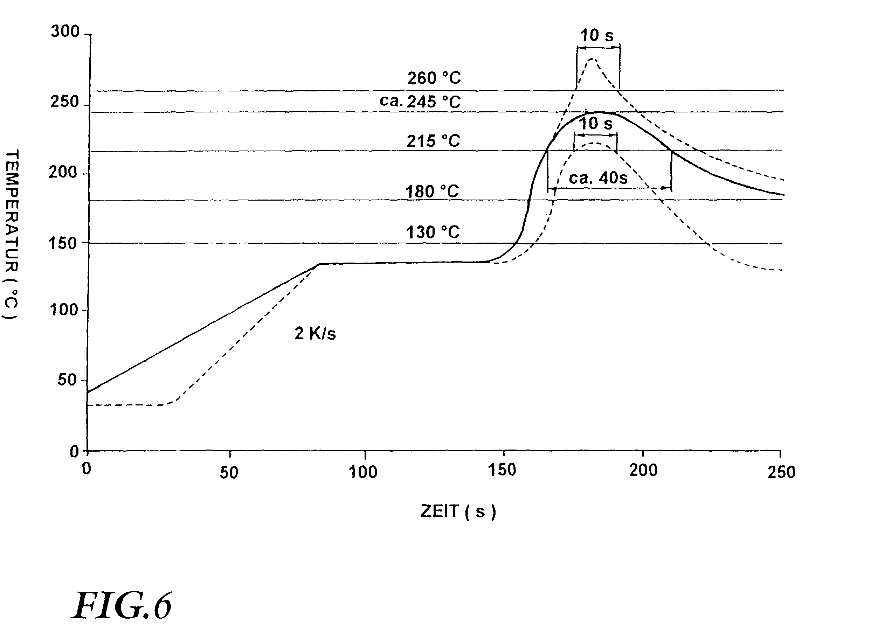

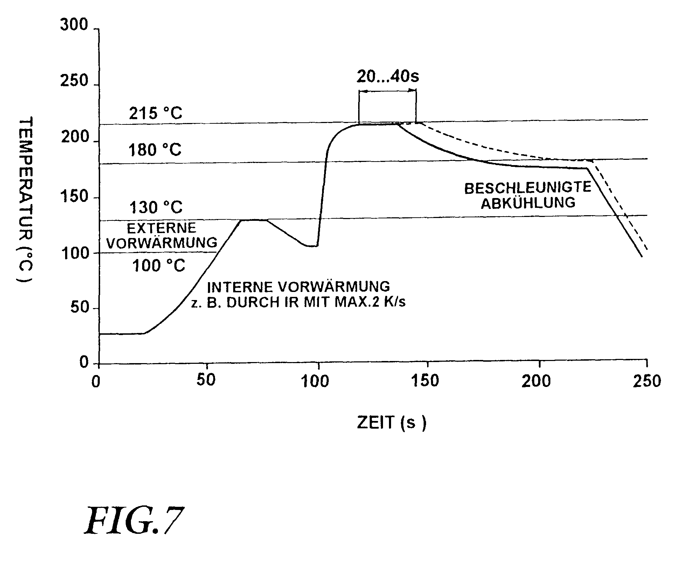

Die Lötwärmebeständigkeit von oberflächenmontierten Bauelementen wird in der Norm CECC 00802 "Genormtes CECC Verfahren zur Spezifizierung oberflächenmontierbarer Bauelemente mit Gütebestätigung" beschrieben. SMD's haben im Vergleich zu bedrahteten Bauelementen eine prozeßbedingte wesentlich höhere Lötwärmebeständigkeit und verfahrensbedingt auch eine höhere zulässige Umgebungstemperatur. Sie sind so ausgebildet, daß sie bei vollständigem Eintauchen sowohl beim Reflowlöten als auch beim Dampfphasenlöten die geforderten Grenztemperaturen von 260 °C (Fig. 6) bzw. 215 °C (Fig. 7) ohne Zerstörung und Funktionsbeeinträchtigungen überstehen.

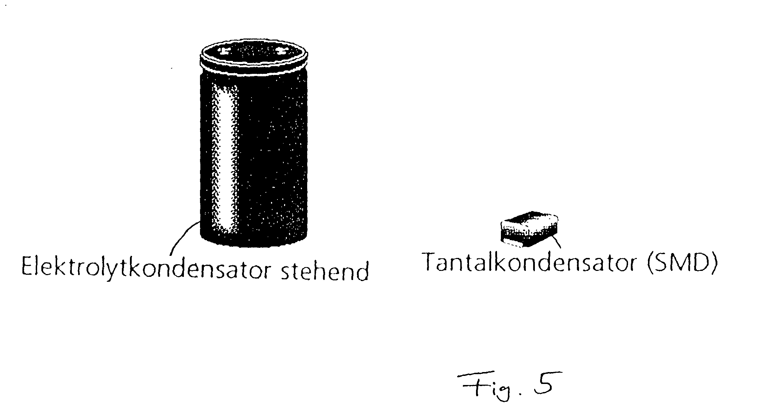

Durch das erfindungsgemäße Verfahren mit einem nur teilweise Eintauchen der wärmeempfindlichen Bauelemente, insbesondere stehender, bedrahteter Elektrolytkondensatoren (siehe Fig. 5), ist eine Baugruppe mit Mischbestückung (bedrahtete Bauelemente, SMD's) in einem einzigen Prozeßschritt (Wellen- und Dampfphasenlöten) ohne Zerstörung der Elektrolytkondensatoren lötbar. Wohingegen bei einem verfahrenstypischen Temperatur-Zeit-Verlauf beim bekannten, alleinigen Dampfphasenlöten (Fig. 7) oder Reflowlöten (Fig. 6) die bedrahteten Elektrolytkondensatoren durch Verdampfen vollständig zerstört werden. Weitere wärmeempfindliche Bauelemente sind Bauteile, die nichttemperaturbeständige Kunststoffe enthalten, wie etwa Stecker und Schalter.

Durch das teilweise Eintauchen der wärmeempfindlichen Bauelemente werden die unterschiedlichen Wärmeübertragungsarten zur Begrenzung der Erwärmung der Bauelemente vorteilhaft ausgenutzt. Im Dampf erfolgt der Wärmetransport überwiegend durch ein Kondensieren der verdampften Flüssigkeit an die zu lötende kältere Masse. Weiterhin wird in geringem Umfange durch auskondensierte Tröpfchen, die sich auf der zu lötenden Masse niederschlagen, Wärme übertragen. Im Bereich oberhalb des gesättigten Dampfes bildet sich ein Aerosol bestehend aus Luft und schwebenden Tröpfchen des Siedemediums. Eine Wärmeübertragung auf die Bauelemente erfolgt durch Konvektion der Luft und durch Ankondensation der Tröpfchen auf der Bauelementeoberfläche. Die Wärmeübertragung im Bereich des Aerosols ist daher wesentlich geringer als im Dampf. In einer besonderen Ausführungsform der Erfindung wird mit einer Absaugung des Aerosols die Erwärmung über der Dampfdecke weiter reduziert.

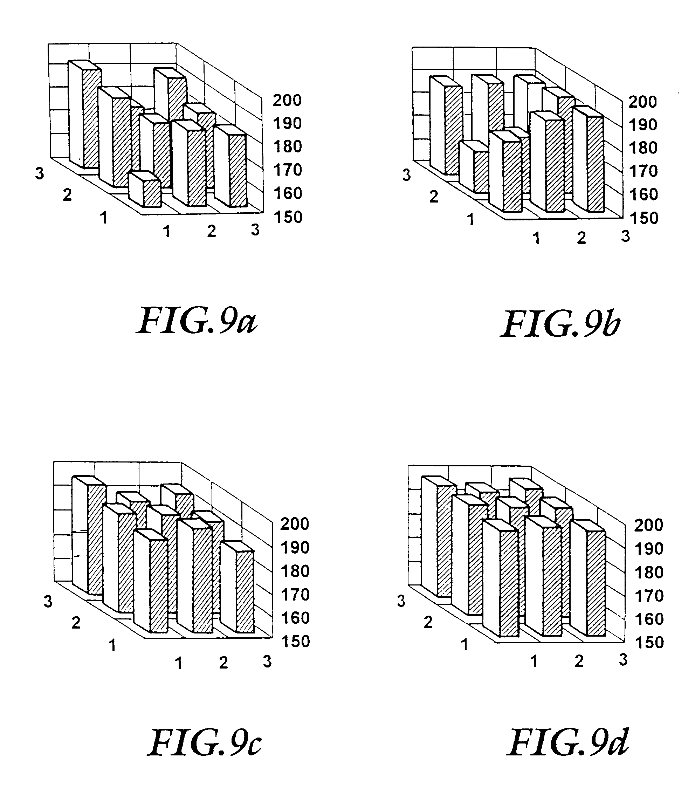

Zur Regulierung des Volumens, das vom gesättigten Dampf der Primärflüssigkeit in der Kammer ausgefüllt wird, sind Kühleinrichtungen vorgesehen, mit denen die Höhe der Dampfdecke, d. h. der Grenzfläche zwischen gesättigtem Dampf und übrigem Kammervolumen bzw. dem Aerosol, auf einen bestimmten Wert eingestellt wird. Je nach Ausführungsform der erfindungsgemäßen Vorrichtung ist die Höhe der Dampfdecke leicht ortsabhängig, wobei die Höhe an den Kammerwänden etwas größer ist als im Innern der Kammer. Die auskondensierten Flüssigkeitstropfen wandern überwiegend wieder nach unten in den Siedebereich. Es hat sich experimentell herausgestellt, daß die Grenzfläche Dampf-Aerosol bei verminderter Heizleistung nach ca. 60 Sekunden den in den Fig. 9a - Fig. 9d dargestellten Gleichgewichtszustand erreicht. In Fig. 9a sind an neun Stellen einer Leiterplatte der Größe 20 cm x 20 cm, die sich etwa mittig in einer Lötkammer der Größe 30 cm x 40 cm befindet, die jeweiligen Temperaturen angegeben, und zwar unmittelbar nachdem die Leiterplatte an die Grenzfläche Dampf-Aerosol gefahren wurde. In Fig. 9b bis Fig. 9d ist bei festgehaltener Leiterplatte die Einstellung eines Temperatur-Gleichgewichtes ablesbar. Die an den Metallteilen in einer erfindungsgemäßen Lötanlage sichtbare Grenzlinie der Dampfdecke (hell-dunkel Übergang durch Auskondensieren) wird in der gesamten Fläche gleichmäßig erreicht. Durch Sensoreinrichtungen, insbesondere Temperaturfühler, zur Bestimmung der Dampfdeckenhöhe ist mittels einer Steuerelektronik für die Kühleinrichtungen die Dampfdeckenhöhe regelbar.

Als Kühleinrichtungen werden in einer Ausführungsform des erfindungsgemäßen Verfahrens Rohrsysteme verwendet, die von einem kühlendem Medium durchströmt werden. Die Rohrsysteme sind vorzugsweise an den Kammerseitenwänden mechanisch verschiebbar angebracht und spiralförmig ausgebildet. Des weiteren sind zur Veränderung des Dampfvolumens als Kühlplatten ausgebildete Kühlfallen in das vom Dampf ausgefüllte Volumen einbringbar, insbesondere drehbar einschwenkbar. Kühlfallen haben eine besonders große Kondensatfläche und eignen sich daher vorzugsweise zur schnellen Veränderung einer vergleichsweise großen Dampfdeckenhöhendifferenz.

Bei einer weiteren Ausgestaltung des erfindungsgemäßen Verfahrens werden auf die Baugruppe eine oder mehrere kühlende Abschirmeinrichtungen mit geschlossener oder netzartiger Struktur aufgebracht, wobei dieses Aufbringen vorzugsweise vor dem Einführen der Baugruppe in die Kammer erfolgt. Die kühlenden Abschirmeinrichtungen verhindern, daß der gesättigte Dampf über die jeweilige Abschirmeinrichtung hinaus weiter in die Höhe steigt. Dadurch wird ein vollständiges Eintauchen der abgeschirmten Bauteile in den Dampf vermieden.

Ferner ist das Dampfvolumen, insbesondere die Dampfdeckenhöhe durch das Einbringen einer Flüssigkeit mit einer Temperatur, die niedriger als die Temperatur des Primärflüssigkeitsdampfes ist, in den Dampf regulierbar. Vorzugsweise wird als Flüssigkeit die Primärflüssigkeit selbst gewählt, welche durch geeignete Düsenanordnungen in die Kammer und damit auch in den Dampf einbringbar, insbesondere einspritzbar, ist. Dies ermöglicht eine schnelle und durch eine genau dosierte Zugabe der kalten Flüssigkeit zudem eine genaue Beeinflussung des Dampfvolumens, insbesondere der Dampfdeckenhöhe. Zusammen mit Sensoreinrichtungen zur Bestimmung der aktuellen Dampfdeckenhöhe ist mit dem dosierten Einspritzen von Primärflüssigkeit in den Dampf eine genaue und schnelle Regelung der Dampfdeckenhöhe realisierbar.

In einer weiteren Ausführungsform des erfindungsgemäßen Verfahrens ist das Dampfvolumen dadurch einstellbar und regelbar, daß die Öffnungen, insbesondere eine oder mehrere Düsen, durch welche der gesättigte Primärflüssigkeitsdampf in die Kammer eingeleitet wird, teilweise oder auch ganz verschlossen werden. Abgesehen von den Einbringöffnungen für den Dampf sind dafür auch andere Ventileinrichtungen in den Dampfzuleitungen zur Kammer verwendbar. Das restliche Kammervolumen ist ferner gleichzeitig mit einem Schutzgas, insbesondere einem Edelgas oder Stickstoff, füllbar. Letzteres dient der Abschirmung der Baugruppe und/oder der Lotwelle.

Das erfindungsgemäße Verfahren gestattet es, je nach Bestückung der elektronischen Baugruppe entweder nur das Wellenlöten oder nur das Reflowlöten durchzuführen oder aber beide in einem einzigen Verfahrensschritt zum Löten der Baugruppe einzusetzen.

In einer Ausführungsform des erfindungsgemäßen Verfahrens wird die zu lötende elektronische Baugruppe in einem oder mehreren Verfahrensschritten, die dem eigentlichen Lötprozeß vorgelagert sind, auf eine bestimmte Temperatur vorerwärmt, um ein schlagartiges Erwärmen der Baugruppe zu vermeiden, um eine gleichmäßige Temperaturverteilung zu erzielen und um einem gegebenenfalls verwendeten Flußmittel die nötige Aktivierungszeit zu geben. Mit dem Vorerwärmen werden bekanntermaßen insbesondere Fehler wie z. B. Tombstoning (d. h. dem Aufrichten von Bauelementen aufgrund örtlich unterschiedlichem Aufschmelzen des Lotes) minimiert. Als Energieträger für die Vorerwärmung wird vorzugsweise Infrarotstrahlung benutzt, die entweder direkt auf die zu erwärmende elektronische Baugruppe gerichtet oder mittels Reflektoren auf die Baugruppe geleitet wird. Vorzugsweise erfolgt die Vorerwärmung noch vor dem Einführen der Baugruppe in die mit dem Primärflüssigkeitsdampf zumindest teilweise gefüllte Lötkammer.

In einer weiteren Ausführungsform des erfindungsgemäßen Verfahrens wird zur Vorerwärmung einer elektronischen Baugruppe erwärmte Primärflüssigkeit auf die Baugruppe aufgebracht, wozu vorteilhafterweise an der Kammerdecke angebrachte Düsen verwendet werden.

In einer anderen Ausführungsform des erfindungsgemäßen Verfahrens wird zur Vorerwärmung einer elektronischen Baugruppe ein zumindest einen Teil des Kammervolumens ausfüllender gesättigter Dampf, insbesondere ein der Vorerwärmtemperatur angepaßter Dampf, verwendet.

Beim erfindungsgemäßen Verfahren sind die Temperaturen auf der Baugruppenträgeroberseite und der Baugruppenträgerunterseite auf verschiedene Werte einstellbar, was insbesondere durch die unterschiedliche Wahl der Siedetemperatur der Primärflüssigkeit und der einstellbaren Lotwellentemperatur vorgenommen wird. Bei der gemeinsamen Verwendung von Wellenlöten und Dampfphasenlöten in einem einzigen Verfahrensschritt gestattet es das erfindungsgemäße Verfahren, die Löttemperatur gleich oder geringfügig höher als die Schmelztemperatur des Lotmaterials zu wählen. Insbesondere wird eine Primärflüssigkeit verwendet, deren Siedetemperatur gleich oder etwas größer als die Löttemperatur ist. Durch geeignete Wahl der Lottemperatur erfüllt die Lotwelle unterschiedliche Aufgaben. Sie kann zum Auftragen des Lotmaterials auf die Unterseite der Baugruppenträger dienen, sie kann darüber hinaus auch zumindest einen Teil der Energie zum Wellenlöten liefern. Schließlich kann die Lotwelle beim Dampfphasenlöten neben der aus dem kondensierten Dampf freiwerdenden Energie einen zusätzlichen Energiebeitrag zuführen, so daß das Dampfphasenlöten in einer kürzeren Zeit erfolgt und die geforderte Qualität der damit hergestellten Lotverbindungen zuverlässig erreicht wird.

Das erfindungsgemäße Verfahren ist vorteilhaft insbesondere zum Löten von bleifreien Loten, deren Schmelztemperatur über der eutektischen Temperatur von Blei-Zinn-Lot (ca. 183° C) liegt, einsetzbar. Da die Lotwellentemperaturen bekannter Lotwellenmodule zwischen etwa 240 °C und 270° C liegen, sind mit dem erfindungsgemäßen Verfahren besonders die bleifreien Lote, mit Schmelztemperaturen zwischen ca. 183° C und ca. 270° C, bei den Prozeßtemperaturen, d. h. Lotwellentemperaturen, herkömmlicher Lötwellenanlagen lötbar. Das ist insbesondere für Zinn-Silber-Lote von Bedeutung. Für ein Zinn-Silber-Lot mit einer Schmelztemperatur von 221° C müßte mit einem bekannten Wellenlötverfahren eine Lotwellentemperatur von ca. 270° C gewählt werden, für das erfindungsgemäße Verfahren genügt eine Lotwellentemperatur, die geringfügig über der Schmelztemperatur von 221° C liegt.

Eine erfindungsgemäße Vorrichtung zum Löten elektronischer Baugruppen, insbesondere zur Durchführung eines erfindungsgemäßen Verfahrens zum Löten elektronischer Baugruppen, besteht aus einer Kammer, welche zumindest in einem Teil des Kammervolumens von einem gesättigten Dampf einer Primärflüssigkeit erfüllt ist, und ferner einer Einrichtung zum Wellenlöten, welche sich zumindest teilweise innerhalb der Kammer befindet, sowie einer Einrichtung zum Transport einer elektronischen Baugruppe in die Kammer, durch die Kammer und aus der Kammer, wobei eine Einrichtung vorhanden ist, mit der das vom gesättigten Dampf ausgefüllte Kammervolumen variabel einstellbar ist.

In einer Ausführungsform der erfindungsgemäßen Vorrichtung sind ferner eine oder mehrere Vorwärmeinrichtungen für eine oder mehrere elektronische Baugruppen, die anschließend in der Kammer gelötet werden sollen, vorgesehen. Dabei ist eine solche Einrichtung zur Vorerwärmung entweder in der Kammer oder vorzugsweise außerhalb der Kammer angebracht. Vorzugsweise werden zur Vorerwärmung ein oder mehrere Infrarotstrahler und/oder Infrarotstrahlung reflektierende Komponenten benutzt.

Weiterhin ist in einer Ausführungsform der erfindungsgemäßen Vorrichtung eine Einrichtung in der Kammer und/oder in den Kammerwänden vorhanden, mit welcher erhitzte Primärflüssigkeit auf eine elektronische Baugruppe zu deren Vorerwärmung aufbringbar ist. Bevorzugtermaßen besteht die Einrichtung aus einer oder mehreren Düsen, durch welche die erwärmte Primärflüssigkeit auf die Baugruppe gesprüht wird.

Nach erfolgtem Lötprozeß in der Kammer wird die gelötete elektronische Baugruppe mittels einer Transporteinrichtung wieder aus der Kammer, und zwar vorzugsweise durch eine Ausgangsschleuse, hinausgebracht. Nach der Kammerausgangsschleuse ist eine Kühl- und Abdampfeinrichtung vorhanden, wo die Abkühlung einer elektronischen Baugruppe unter definierten Bedingungen vornehmbar ist.

In einer Ausführungsform der erfindungsgemäßen Vorrichtung ist für die Primärflüssigkeit ein Reservoir bzw. ein Vorratsbehälter vorhanden, in dem oder an dem eine Heizeinrichtung angebracht ist, welche zum Erhitzen der Primärflüssigkeit bis zum Siedepunkt dient. Vorzugsweise befindet sich das Primärflüssigkeitsreservoir innerhalb der Kammer auf dem Kammerboden, von wo aus der erzeugte gesättigte Primärflüssigkeitsdampf einen Teil des Kammervolumens vom Kammerboden bis zu einer variabel festlegbaren Höhe ausfüllt. Die Primärflüssigkeit ist vorzugsweise elektrisch nicht leitend, nicht oxydierend, außerdem chemisch stabil und reaktionsträge, ungiftig, nicht entflammbar und weist eine größere Dichte als Luft auf. Sie hat vorteilhafterweise eine ziemlich hohe latente Verdampfungswärme und einen definierten Siedepunkt. Um den Siedepunkt möglichst genau festzulegen, besteht die Primärflüssigkeit lediglich aus einer einzigen Flüssigkeitskomponente. Bei einer weiteren Ausgestaltung der Erfindung ist das restliche Kammervolumen, abgesehen vom gesättigten Dampf und gegebenenfalls der Primärflüssigkeit sowie der Lotwelleneinrichtung, mit einem Schutzgas, insbesondere einem Edelgas oder Stickstoff, gefüllt, wozu entsprechende Einfüllöffnungen vorhanden sind.

Bei einer anderen Ausführungsform der erfindungsgemäßen Vorrichtung befindet sich das Primärflüssigkeitsreservoir außerhalb der Kammer, wobei eine oder mehrere Leitungen für den gesättigten Primärflüssigkeitsdampf vom Reservoir zur Kammer führen und der Dampfstrom mit einer Ventileinrichtung regulierbar ist. Vorzugsweise sind an einem solchen Leitungsende an der Kammerwand Düsen angebracht, die zumindest teilweise verschließbar sind und somit eine Ventilfunktion ausüben.

Eine erfindungsgemäße Vorrichtung enthält eine oder mehrere Kühleinrichtungen zur variablen Einstellung des vom Primärflüssigkeitsdampf ausgefüllten Kammervolumens. Insbesondere ist damit die im allgemeinen ortsabhängige Dampfdeckenhöhe einstellbar und/oder auf vorgebbare, ortsabhängige Höhenwerte regelbar. Zumindest im Bereich der zum Löten in die Kammer eingebrachten elektronischen Baugruppe ist die Dampfdecke vorzugsweise nahezu als ebene Fläche ausgebildet und die Dampfdeckenhöhe zumindest in diesem Bereich auf wenige Millimeter genau einstell- und/oder regelbar. In einer bevorzugten Ausführungsform der Erfindung ist die Dampfdecke, d. h. die Grenzfläche zwischen dem gesättigten Dampf im unteren Teil der Kammer und dem übrigen Kammervolumen, ganz als ebene Fläche ausgebildet, so daß zur Angabe der Höhe dieser Grenzfläche, der Dampfdecke, ein einziger Höhenwert genügt.

Ferner sind diese Kühleinrichtungen am besten an den Seitenwänden der Kammer mechanisch verschiebbar angebracht. Sie sind vorteilhaft als Rohrsysteme, welche von einem kühlenden Medium durchströmt werden, ausgebildet und/oder bestehen aus mehreren Teilrohrsystemen, die unabhängig voneinander zur Einstellung einer bestimmten Dampfdeckenhöhe kühlbar sind.

Des weiteren sind als Kühlfallen ausgebildete Kühlplatten mit einer vergleichsweise großen Kondensatfläche vorgesehen, die in das mit gesättigtem Primärflüssigkeitsdampf ausgefüllte Kammervolumen einbringbar sind. Die Kühlplatten sind vorzugsweise an einer Kammerwand nahe der Kammerdecke drehbar angebracht und nahezu parallel zur Kammerdecke ausgerichtet, von wo aus sie drehend in den Dampf einschwenkbar sind.

Die Dampfdeckenhöhe ist weiterhin durch kühlende Abschirmeinrichtungen, welche einer elektronischen Baugruppe aufgesetzt sind, regulierbar, insbesondere auch lokal. Durch eine geeignete geometrische Ausbildung einer Abschirmeinrichtung, die insbesondere die Orte und geometrischen Abmessungen der temperaturempfindlichen Bauelemente der Baugruppe zu berücksichtigen hat, sind gerade diese Bauelemente vor einer zu hohen Temperaturbelastung und einer dadurch bedingten Schädigung oder Zerstörung geschützt.

Darüber hinaus sind in einem anderen Ausführungsbeispiel der erfindungsgemäßen Vorrichtung Düsensysteme, insbesondere an der Kammerdecke und/oder an den benachbarten Kammerwänden, vorgesehen, die ein dosiertes Einbringen von Primärflüssigkeit in die Kammer und in den gesättigten Primärflüssigkeitsdampf gestatten. An den eingebrachten Primärflüssigkeitströpfchen kondensiert der Dampf, worauf sich die Dampfdeckenhöhe verringert bzw. in der Kammer nach unten in Richtung Lotwelle verschiebt.

Eine erfindungsgemäße Vorrichtung enthält ferner Ableiteinrichtungen für den an Kühleinrichtungen kondensierten Primärflüssigkeitsdampf, wobei diese Ableiteinrichtungen vorzugsweise so ausgebildet sind, daß sie das Kondensat zurück in das Primärflüssigkeitsreservoir leiten.

Ferner beinhaltet eine erfindungsgemäße Vorrichtung eine Einrichtung zum Wellenlöten, ein Wellenlötmodul, das eine Lotwelle bereitstellt. Dabei wird vorzugsweise eine elektrodynamische Lotpumpe eingesetzt. Solange keine Baugruppe mit der Lotwelle in Kontakt steht, ist die Lotwelle gänzlich von gesättigtem Dampf umgeben. Der gesättigte Dampf stellt somit für die Lotwelle einen Oxidationsschutz dar. Auch das Lot, aus welchem die Lotwelle emporgepumpt wird, das sogenannte Lotbad, ist durch den gesättigten Dampf vor Oxidation geschützt. In der Abkühlphase, d. h. bei abnehmendem Dampfvolumen, wird Primärflüssigkeit als Oxidationsschutz für das Lotbad verwendet. Dazu wird insbesondere zu Primärflüssigkeit kondensierter Dampf mittels Ableiteinrichtungen zur Abdeckung auf die Lotbadoberfläche geleitet. In einem weiteren Ausführungsbeispiel der Erfindung wird aus dem Primärflüssigkeitsreservoir oder anderweitig verfügbare Primärflüssigkeit zu demselben Zwecke auf die Lotbadoberfläche geleitet.

Eine Transporteinrichtung für eine elektronische Baugruppe ist in einer erfindungsgemäßen Vorrichtung so ausgebildet, daß ein Lotwinkel zwischen 0° C und ca. 10° C einstellbar ist. Dabei ist der Lotwinkel festgelegt als der Winkel zwischen der Tangentialebene im höchsten Punkt der Lotwelle und der Ebene des Baugruppenträgers.

In einer anderen Ausführungsform der erfindungsgemäßen Vorrichtung ist vor der Lötprozeß-Einheit eine Einrichtung zum Erkennen einer elektronischen Baugruppe, insbesondere der Art der zu lötenden Bauelemente, vorgesehen. Aus den so ermittelten charakteristischen Daten der Baugruppe bzw. der Bauelemente sind mit einer Steuereinheit relevante Lötparameter einstellbar bzw. auf die jeweils zu lötende spezifische Baugruppe anpaßbar. So ist etwa nur das Wellenlöten oder nur das Dampfphasenlöten verwendbar und/oder die Lotwellentemperatur änderbar. Eine Erkennungseinrichtung wird vorzugsweise außerhalb der Kammer noch vor dem Einführen einer Baugruppe durch eine Eingangsschleuse in Kammer zum Einsatz kommen. Sie ist vorteilhaft als Kamerasystem ausgebildet.

Weitere Vorteile des erfindungsgemäßen Verfahrens und der erfindungsgemäßen Vorrichtung sind nachfolgend aufgeführt.

Die Erfindung ermöglicht das Löten von oberflächenmontierbaren, durchgesteckten und wärmeempfindlichen Bauelementen in einem einzigen Verfahrensschritt und in einem einzigen Gerät bzw. einer Kammer. Damit eröffnet sich für die Fertigung beliebiger Montageaufbauten mit einem erfindungsgemäßen Lötgerät, das insbesondere als Durchlauf-Anlage ausgebildet ist, eine kostengünstige Massenproduktion unter Beibehaltung einer hohen Lötqualität.

Gleichzeitig mit dem Vorteil der Lötbarkeit temperaturempfindlicher Bauelemente wird durch die Erfindung auch eine geringere Temperaturbelastung der anderen Bauelemente sowie des Baugruppenträgers erzielt. Insgesamt wird eine erhöhte Zuverlässigkeit der hergestellten Lotverbindungen erreicht.

Das Zusammenwirken von inerter Dampfphase und Wellenlöten vermindert die Zapfen- und Brückenbildung derart, daß mit der Erfindung Baugruppen bis zu einem Rastermaß von 0,3 mm, anstelle bisherigen 0,5 mm, gelötet werden können. Da mit der Auswahl der Siedetemperatur der Primärflüssigkeit die Dampftemperatur auf der Baugruppenträgeroberseite, d. h. der vornehmlichen Bestückungsseite, eingestellt werden kann, somit auch gleich oder etwas höher als die Schmelztemperatur des Lotmaterials gewählt werden kann, muß die Lotwelle keinen zusätzlichen Energiebeitrag mehr zum Dampfphasenlöten liefern. Die Lotwelle kann deshalb auch mit einer Temperatur betrieben werden, die der Löttemperatur entspricht oder nur geringfügig höher ist. Die Erfindung ermöglicht demnach eine Senkung der Löttemperatur in die Nähe der Schmelztemperatur des Lotes.

Das hat den weiteren Vorteil zur Folge, daß bleifreie Lote, mit Schmelztemperaturen bis zu den heute üblichen Lotwellentemperaturen von ca. 270° C, gelötet werden können. Mit herkömmlichen Wellenlötanlagen können bleifreie Lote wegen der erforderlichen ca. 50° C Temperaturdifferenz zwischen Lotwellentemperatur und Löttemperatur allenfalls mit Schmelztemperaturen bis 220° C gelötet werden.

Die Verwendung eines Primärflüssigkeitsdampfes nicht nur zum Dampfphasenlöten sondern auch als inertes Medium hat den Vorteil, daß zum inerten Löten kein Schutzgas oder Vakuum notwendig ist und somit auf damit verbundene Kontroll-, Regel- und Sicherheitseinrichtungen verzichtet werden kann. Des weiteren ermöglicht das Zusammenwirken von Wellenlöten und Dampfphase, daß beim Wellenlötmodul auf das sonst übliche Abdecköl verzichtet werden kann, da der gesättigte Primärflüssigkeitsdampf gleichzeitig die Abdeckung des Lotbades als Oxidationsschutz wahrnimmt. Der gesättigte Dampf ist also Energieträger für das Löten und Oxidationsschutz zugleich.

In einer Ausführungsform der Erfindung wird zur Vorerwärmung der zu lötenden Baugruppe erwärmte Primärflüssigkeit verwendet. Damit existiert mit der Primärflüssigkeit und ihrem gesättigten Dampf ein einheitliches Medium als Energieträger fürs Löten, als Oxidationsschutz und zur Vorerwärmung.

Die Transport- und/oder Plazierungseinrichtung für eine elektronische Baugruppe erlaubt den Transport bzw. die Plazierung der Baugruppe mit einer bestimmten Genauigkeit und Stabilität. Auch die Dampfdeckenhöhe ist je nach Ausführungsbeispiel der Erfindung mit einer konstruktiv bedingten Genauigkeit einstellbar und/oder regelbar. Mit beiden Maßnahmen alleine oder in Kombination wird in der Erfindung erreicht, daß die wärmeempfindlichen Bauteile höchstens teilweise sich im gesättigten Primärflüssigkeitsdampf befinden. Das hat den Vorteil, diejenige der zuvor genannten Maßnahmen bei der Feinregulierung anzuwenden, welche die größere Genauigkeit und/oder höhere Stabilität aufweist. Wird beispielsweise nach dem Lötvorgang die Dampfdeckenhöhe erniedrigt und dabei die Baugruppe in ihrer Position unverändert gehalten, so ist zumindest in dieser Phase ein nahezu erschütterungsfreies Abkühlen des flüssigen Lotes auf dem Baugruppenträger realisierbar.

Nachfolgend wird die Erfindung anhand von Zeichnungen an Ausführungsbeispielen beschrieben. Es zeigen:
- Fig. 1:: Querschnittsdarstellung einer erfindungsgemäßen Vorrichtung zum Wellen- und/oder Dampfphasenlöten mit einem Primärflüssigkeitsreservoir in der Lötkammer
- Fig. 2:: Querschnittsdarstellung einer erfindungsgemäßen Vorrichtung zum Wellen- und/oder Dampfphasenlöten mit einem Primärflüssigkeitsreservoir außerhalb der Lötkammer
- Fig. 3:: Querschnittsdarstellung einer Lötkammer mit Kühleinrichtungen zur Steuerung der Dampfdeckenhöhe des Primärflüssigkeitsdampfes
- Fig. 4:: Aufsichtsdarstellung auf einen Lötkammerboden mit Lotbad und Kondensatrinne
- Fig. 5:: Vergleich unterschiedlicher Bauelementetypen
- Fig. 6:: Infrarotlöten, Temperatur-Zeit-Diagramm (Temperatur am Anschluß) nach CECC 00802 (durchgezogene Linie: verfahrenstypisch; unterbrochene Linie: Verfahrensgrenzen)
- Fig. 7:: Dampfphasenlöten, Temperatur-Zeit-Diagramm (Temperatur am Anschluß) nach CECC 00802 (durchgezogene Linie: verfahrenstypisch; unterbrochene Linie: Verfahrensgrenzen)
- Fig. 8:: Doppelwellenlöten, Temperatur-Zeit-Diagramm (Temperatur am Anschluß) nach CECC 00802 (durchgezogene Linie: verfahrenstypisch; unterbrochene Linie: Verfahrensgrenzen)
- Fig. 9a-d:: Temperaturverteilung an neun Stellen einer Leiterplatte nach dem Einbringen der Leiterplatte in die Grenzfläche Dampf-Aerosol.

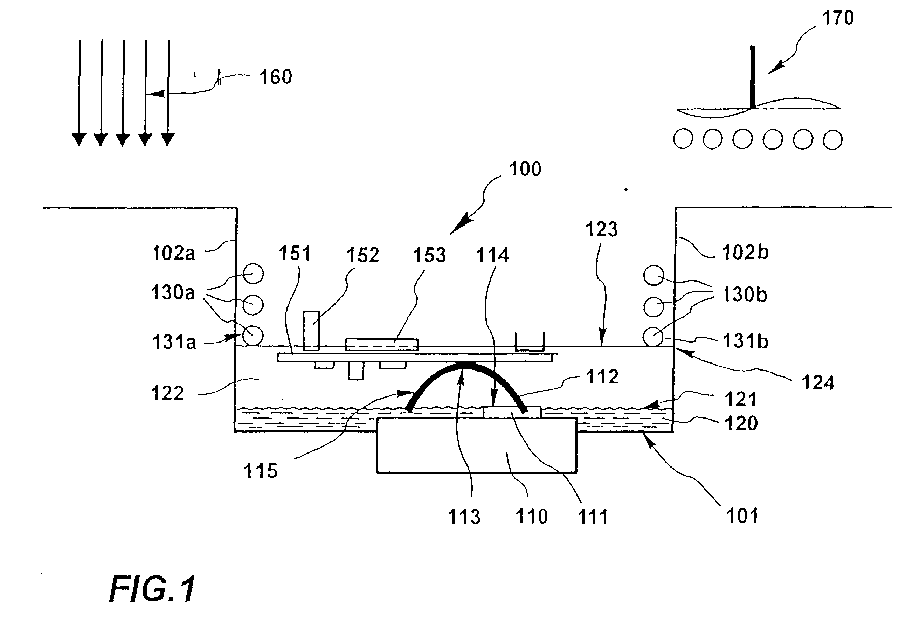

Ein erstes Ausführungsbeispiel einer erfindungsgemäßen Vorrichtung ist in Fig. 1 dargestellt. Fig. 1 zeigt eine Lötkammer (100), in welche ein Teil eines Lotwellenmoduls (110) hineinragt. Der untere Raumteil der Lötkammer dient gleichzeitig als Primärflüssigkeitsreservoir, wobei die Primärflüssigkeit (120) den Kammerboden (101) bedeckt und bis zu einer festgelegten Höhe in der Kammer reicht. Durch eine in Fig. 1 nicht dargestellte Heizeinrichtung wird die Primärflüssigkeit verdampft. Der gesättigte Primärflüssigkeitsdampf (122) erfüllt einen Teil des Kammervolumens direkt oberhalb der Primärflüssigkeitsoberfläche (121). Nach oben wird der Primärflüssigkeitsdampf durch seine Dampfdecke (123) begrenzt, wobei die Dampfdeckenhöhe (124) durch an den Seitenwänden (102 a), (102 b) der Kammer angebrachte Kühleinrichtungen (130 a), (130 b) auf einen gewünschten Wert eingestellt wird.

Die Kühleinrichtungen (130 a), (130 b) sind parallel zu den Seitenwänden in Richtung des Kammerbodens in den Dampf eintauchbar und auch wieder herausfahrbar (Genauigkeit ± 0,5 mm). Sie sind in der in Fig. 1 gezeigten Ausführungsform als Rohrsysteme (130 a), (130 b) ausgebildet, durch welche als Kühlmedium Wasser oder Primärflüssigkeit oder flüssiger Stickstoff geleitet wird. An der Unterkante des untersten Kühlrohres (131 a), (131 b) kondensiert der aufsteigende Dampf (122), weshalb durch die Unterkante dieses Kühlrohres die Dampfdeckenhöhe (124) bestimmt wird. Die Kühleinrichtungen sind so ausgebildet und auf die Lötkammer abgestimmt, daß sich bei jeder eingestellten Dampfdeckenhöhe eine nahezu waagrechte und ebene Dampfdecke (123) einstellt. Die Genauigkeit, mit der die Dampfdeckenhöhe einstellbar ist, ist durch die spezielle geometrische Ausbildung der kühlenden Rohrsysteme und ihrer mechanischen Verschiebeeinrichtung, z. B. durch Spindeltriebe oder Mehrgelenkgetriebe, realisiert.

Das Lotwellenmodul (110) reicht nur teilweise in die Lötkammer (100) hinein. Aus dem Lotbad (111) wird das Lot in Form einer Lotwelle (112) nach oben in den gesättigten Dampf (122) gepumpt, erreicht einen Scheitelpunkt (113) und fließt nach unten wieder in eine Auffangvorrichtung (115) des Lotwellenmoduls zurück. Die Höhe der Lotwelle, insbesondere des Scheitelpunktes, über der Lotbadoberfläche (114) ist unabhängig von der Lotwellentemperatur höhenverstellbar. Die Primärflüssigkeitsoberfläche (121) ist so auf das in die Lötkammer ragende Lotwellenmodul (110) abgestimmt, daß die Lotbadoberfläche (114) und die gesamte Lotwelle nur mit dem gesättigten Dampf (122) in Kontakt stehen, wobei von dem Kontakt der Lotwelle mit einer zu lötenden elektronischen Baugruppe abgesehen wird. In einer anderen Ausführungsform der Erfindung ist die Lotbadoberfläche mit einem flüssigen Medium bedeckt.

Unter Verwendung der in Fig. 1 gezeigten Vorrichtung wird eine elektronische Baugruppe, bestehend aus einem Baugruppenträger (151) mit bestückten Bauelementen, vor dem Einbringen in die Lötkammer (100) mit Infrarotstrahlung (160) vorerwärmt. Mit einer in Fig. 1 nicht dargestellten Transporteinrichtung wird die vorerwärmte Baugruppe in die Kammer (100) weiterbefördert und in der Kammer soweit abgesenkt, daß die Unterseite des Baugruppenträgers (151) in Kontakt mit der Lotwelle (112) nahe dem Scheitelpunkt (113) kommt, und daß die temperaturempfindlichen Bauelemente, etwa (152), (153), nur teilweise, ihre Anschlußbeinchen zum Baugruppenträger jedoch ganz, vom gesättigten Dampf umgeben sind.

Nach dem Lötprozeß wird die elektronische Baugruppe mit der Transporteinrichtung wieder aus dem gesättigten Dampf und hernach aus der Kammer herausgebracht und in einer Kühl- und Abdampfstation (170) unter definierten Bedingungen abgekühlt.

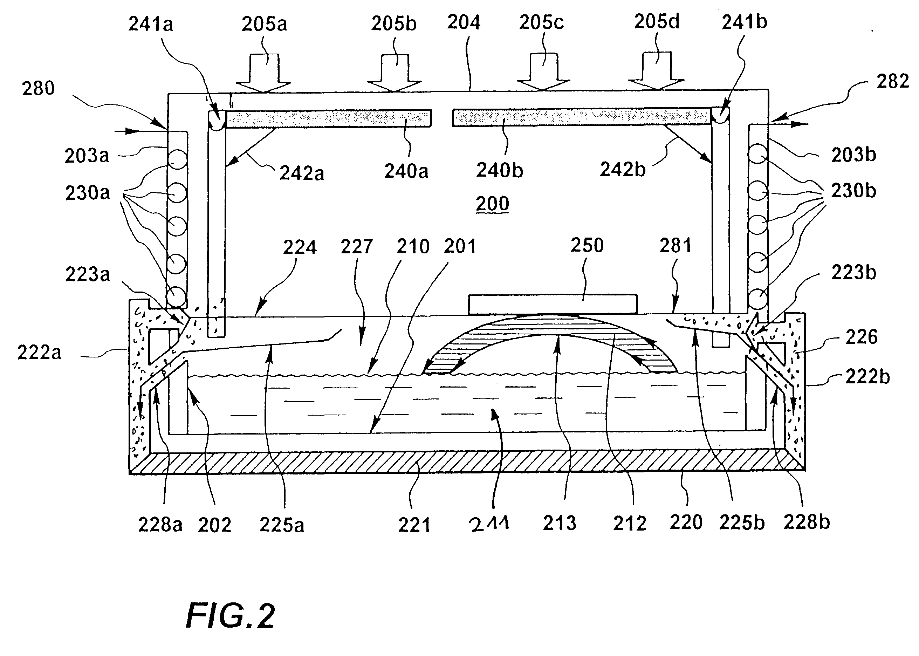

Eine weitere Ausführungsform einer erfindungsgemäßen Vorrichtung ist in Fig. 2 dargestellt. Die Lötkammer (200) enthält in ihrem unteren Teil das Lot, welches als Lotbad (211) den Kammerboden (201) bedeckt und bis zu einer bestimmten Lotbadhöhe (202) reicht. Aus dem Lotbad (211) wird eine Lotwelle (212) nach oben gepumpt, die im Scheitelpunkt (213) ihre maximale Höhe erreicht und danach ins Lotbad (211) zurückfließt. Des weiteren ist außerhalb der Kammer (200) ein Primärflüssigkeitsreservoir (220) angeordnet. Die darin enthaltene Primärflüssigkeit (221) wird mittels Heizeinrichtungen (in Fig. 2. nicht eingezeichnet) verdampft und der erzeugte gesättigte Primärflüssigkeitsdampf (226) über Leitungen (222 a), (222 b) durch Kammeröffnungen (223 a), (223 b) in die Kammer geleitet. Der Primärflüssigkeitsdampf (227) füllt denjenigen Volumenanteil der Kammer aus, der sich von der Lotbadoberfläche (210) bis zu einer durch die Kühleinrichtungen (230 a), (230 b) festgelegten Kammerhöhe (224), die der Dampfdeckenhöhe (224) entspricht, erstreckt. Dabei wird beachtet, daß die Lotwelle (212) immer ganz im Kammervolumen des gesättigten, inerten Primärflüssigkeitsdampfes liegt.

Die Kühleinrichtungen (230 a), (230 b) sind als Rohrsysteme ausgebildet und an den Kammerseitenwänden (203 a), (203 b) mechanisch verschiebbar befestigt. Die Verschieberichtungen weisen dabei in Richtung des Kammerbodens (201) bzw. der Kammerdecke (204), wobei die Verschiebung selbst nahezu parallel zur jeweiligen Kammerwand erfolgt. Unterhalb der an den Kammerseitenwänden angebrachten kühlenden Rohrsysteme (230 a), (230 b) sind Auffangbleche (225 a), (225 b) befestigt, welche die an den kühlenden Rohrsystemen durch Kondensation aus dem gesättigten Dampf (227) gebildete Primärflüssigkeit auffangen und über Leitungen (228 a), (228 b) zurück ins Primärflüssigkeitsreservoir führen.

Ferner sind Kühlplatten (240 a), (240 b) zur Verwendung als Kühlfallen in der Kammer vorgesehen. Sie sind an den Kammerseitenwänden (203 a), (203 b) nur unweit von der Kammerdecke (204) drehbar befestigt (241 a), (241 b) und nahezu waagrecht zur Kammerdecke (204) ausgerichtet und in dieser Ruhestellung verriegelt. Sie sind bei Bedarf entsprechend der durch die Pfeile (242 a), (242b) angezeigten Drehrichtungen in den gesättigten Dampf einschwenkbar. An der Kammerdecke (204) sind darüber hinaus Öffnungen (205 a - d) vorhanden, durch welche ein Schutzgas, etwa ein Edelgas oder Stickstoff, in das restliche Kammervolumen einbringbar ist.

Eine in Fig. 2 nicht näher dargestellte Transporteinrichtung bringt eine zu lötende gegebenenfalls vorerwärmte Baugruppe (250) durch eine Eingangsschleuse an der Stelle (280) in die Kammer, senkt die Baugruppe etwa auf das Niveau des Scheitelpunktes (213) der Lotwelle (212) ab, bringt danach die Baugruppenträgerunterseite mit der Lotwelle (212) in Kontakt (siehe Fig. 2) und führt die gelötete Baugruppe entlang dem Transportweg (281) durch eine Ausgangsschleuse (282) aus der Kammer heraus.

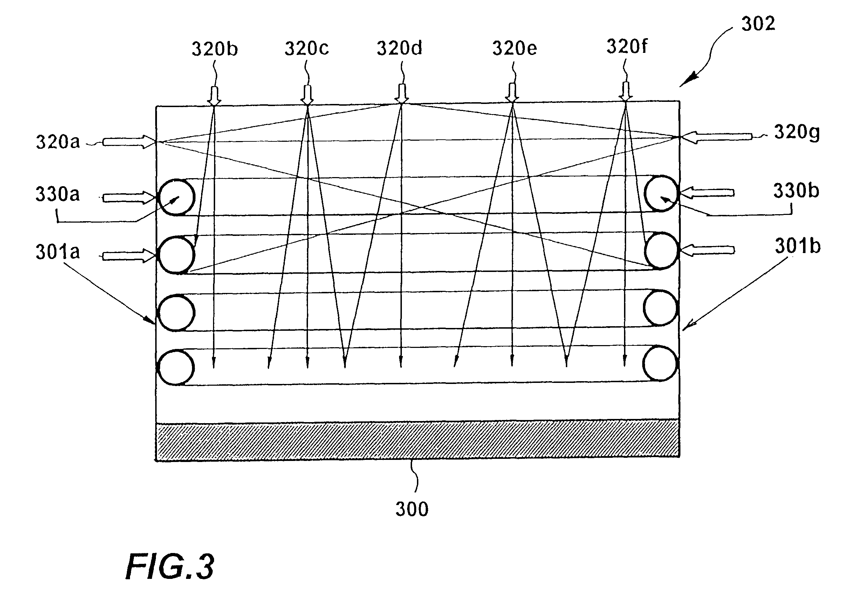

In Fig. 3 sind an einem Ausführungsbeispiel der Erfindung nur Kühleinrichtungen eingezeichnet, welche zum Einstellen und/oder Regulieren der Dampfdeckenform, insbesondere bei ebener Dampfdecke der variablen Einstellung der Dampfdeckenhöhe, dienen. In der Lotkammer (300) sind an den Seitenwänden (301 a), (301 b) als Rohrsysteme (Querschnitt eines Rohres: (330 a), (330 b)) ausgebildete Kühleinrichtungen befestigt, die gemäß den Ausführungsbeispielen in Fig. 1 und Fig. 2 mechanisch verschiebbar sind. Neben der mechanischen Verschiebung des gesamten Rohrsystems an jeder Seitenwand können die einzelnen Rohre auch unabhängig voneinander mit einem kühlenden Medium (etwa Wasser oder Primärflüssigkeit oder flüssiger Stickstoff) beschickt werden und so auf zweierlei Art zur Dampfdeckeneinstellung benutzt werden. Daneben sind an der Kammerdecke (302) und an den benachbarten Kammerseiten Düsen (320 a - g) angebracht, durch die Primärflüssigkeit mit einer einstellbaren Temperatur in genau dosierbarer Menge in die Kammer und damit in den gesättigten Dampf eingespritzt werden kann. Durch Kondensation des Dampfes an den eingebrachten Primärflüssigkeitströpfchen ist eine definierte und schnelle Regulierung der Dampfdecke, insbesondere ihrer Form und ihrer Höhe, erreichbar. Generell sind die benutzten Kühleinrichtungen hinsichtlich des zu erzielenden Zweckes, etwa einer ebenen Dampfdecke und/oder einer genau definierten Dampfdeckenhöhe, geeignet auszubilden und aufeinander abzustimmen.

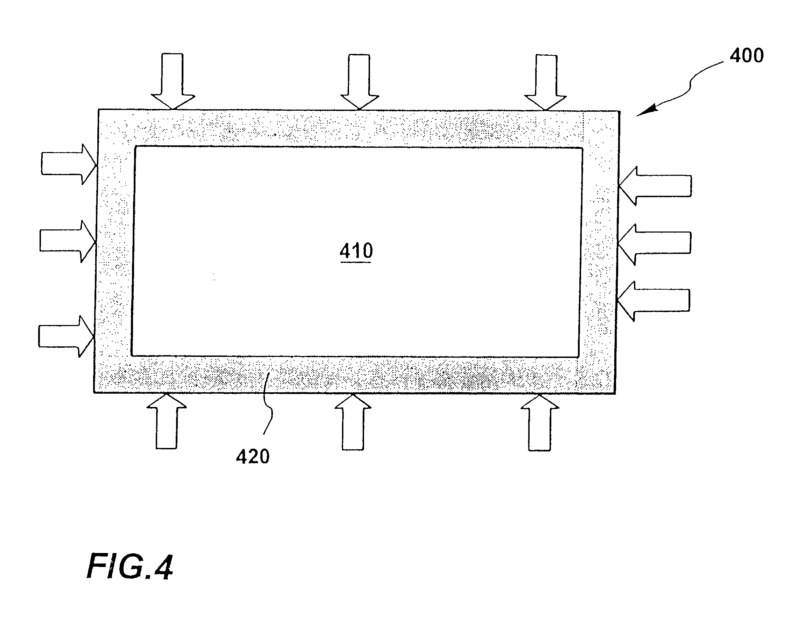

Für eine weitere Ausführungsform der Erfindung ist in Fig. 4 die Aufsicht durch den Primärflüssigkeitsdampf hindurch in Richtung des Kammerbodens einer Lötkammer (400) gezeigt. Der in Fig. 4 nicht zu sehende Kammerboden ist von einem Lotbad (410) bedeckt. Von diesem Lotbad getrennt ist an den Seitenwänden der Lotkammer eine Kondensatrinne (420) für an den Kühleinrichtungen kondensiertem Primärflüssigkeitsdampf angebracht. Der in die Kondensatrinne eingeleitete kondensierte Primärflüssigkeitsdampf ist in Fig. 4 durch die dargestellten Pfeile angedeutet.

In einer anderen Ausführungsform der Erfindung sind die Kühleinrichtungen als Kühlschlangen, vorzugsweise mit kreisförmigem Rohrquerschitt, ausgebildet, wobei die Kühlschlangen zum Erreichen eines hohen Wirkungsgrades der Kühleinrichtung (Aerosolfalle) zudem etwa zur Hälfte in einem Plattenkörper, der insbesondere aus einem Metall besteht, eingeprägt sind.

## Patentansprüche

1. Verfahren zum Löten elektronischer Baugruppen unter Verwendung des Dampfphasenlötens oder einer Kombination von Wellenlöten und Dampfphasenlöten, wobei das Wellenlöten und das Dampfphasenlöten in einer einzigen Kammer (100, 200) durchführbar sind,
**dadurch gekennzeichnet,**
**daß** eine mischbestückte elektronische Baugruppe mit wärmeempfindlichen Bauelementen, insbesondere Elektrolytkondensatoren und Bauelemente, die nichttemperaturstabile Kunststoffe enthalten, so plaziert und der vom gesättigten Dampf einer Primärflüssigkeit erfüllte Volumenanteil der Kammer (100, 200) so reguliert wird, daß sich die wärmeempfindlichen Bauelemente (152, 153) der Baugruppe höchstens teilweise im gesättigten Dampf befinden, und daß die zu lötenden Anschlüsse der Bauelemente (152, 153) der elektronischen Baugruppe sich während des Lötens im gesättigten Dampf befinden.

2. Verfahren nach Anspruch 1,
**dadurch gekennzeichnet,**
**daß** zur Regulierung des Dampfvolumens die Höhe des gesättigten Dampfes in der Kammer (Dampfdecke) auf einen bestimmten Wert eingestellt und/oder auf diesen Höhenwert geregelt wird.

3. Verfahren nach Anspruch 2,
**dadurch gekennzeichnet,**
**daß** zur Veränderung und Einstellung der Dampfdeckenhöhe (124; 224) Kühleinrichtungen verwendet werden.

4. Verfahren nach Anspruch 3,
**dadurch gekennzeichnet,**
**daß** als Kühleinrichtungen (230a, 230b) kühlende Rohrsysteme (130a, 130b) bestimmter Anordnung und geometrischer Ausbildung verwendet werden und/oder Kühlplatten (240a, 240b) in das vom Dampf erfüllte Volumen einbringbar, insbesondere drehbar einschwenkbar, sind und/oder kühlende, geschlossen oder netzartig ausgebildete Abschirmeinrichtungen auf die Baugruppe aufgebracht werden.

5. Verfahren nach einem der Ansprüche 2 bis 4,
**dadurch gekennzeichnet,**
**daß** zur Veränderung und Einstellung der Dampfdeckenhöhe eine Flüssigkeit, insbesondere die Primärflüssigkeit, in das Dampfvolumen eingebracht wird, wobei die Temperatur der Flüssigkeit niedriger als die Temperatur des Dampfes ist.

6. Verfahren nach Anspruch 5,
**dadurch gekennzeichnet,**
**daß** die Primärflüssigkeit über Düsensysteme, insbesondere eine oder mehrere Düsen (320a-g), in die Kammer eingespritzt wird.

7. Verfahren nach einem der Ansprüche 2 bis 6,
**dadurch gekennzeichnet,**
**daß** zur Veränderung und Einstellung der Dampfdeckenhöhe (124, 224) die Öffnungen, insbesondere eine oder mehrere Düsen, durch welche der Dampf in das von ihm erfüllte Kammervolumen strömt, zumindest zum Teil geschlossen werden.

8. Verfahren nach Anspruch 7,
**dadurch gekennzeichnet,**
**daß** das restliche Kammervolumen gleichzeitig mit einem Schutzgas, insbesondere einem Edelgas oder Stickstoff, gefüllt wird.

9. Verfahren nach einem der Ansprüche 1 bis 8,
**dadurch gekennzeichnet,**
**daß** das Wellenlöten und das Dampfphasenlöten in einem einzigen Verfahrensschritt durchgeführt werden.

10. Verfahren nach einem der Ansprüche 1 bis 9,
**dadurch gekennzeichnet,**
**daß** eine elektronische Baugruppe (250) vor dem Löten vorerwärmt wird.

11. Verfahren nach Anspruch 10,
**dadurch gekennzeichnet,**
**daß** als Energieträger für die Vorerwärmung Infrarotstrahlung (160) benutzt wird, und daß die Vorerwärmung außerhalb der Kammer und/oder innerhalb der Kammer erfolgt.

12. Verfahren nach einem der Ansprüche 10 oder 11,
**dadurch gekennzeichnet,**
**daß** zur Vorerwärmung der elektronischen Baugruppe (250) erwärmte Primärflüssigkeit auf die Baugruppe aufgebracht wird.

13. Verfahren nach einem der Ansprüche 10 bis 12,
**dadurch gekennzeichnet,**
**daß** zur Vorerwärmung der elektronischen Baugruppe ein zumindest einen Teil des Kammervolumens erfüllender gesättigter Dampf verwendet wird.

14. Verfahren nach einem der Ansprüche 1 bis 13,
**dadurch gekennzeichnet,**
**daß** die Temperaturen auf der Baugruppenträgeroberseite und der Baugruppenträgerunterseite durch unterschiedliche Wahl der Siedetemperatur der Primärflüssigkeit und der Lotwellentemperatur auf verschiedene Werte einstellbar sind.

15. Verfahren nach einem der Ansprüche 1 bis 14,
**dadurch gekennzeichnet,**
**daß** die Löttemperatur etwas höher als die Schmelztemperatur des Lotes gewählt wird, und/oder daß eine Primärflüssigkeit verwendet wird, deren Siedetemperatur gleich oder etwas höher als die Löttemperatur ist.

16. Verfahren nach einem der Ansprüche 1 bis 15,
**dadurch gekennzeichnet,**
**daß** die Lotwelle (212) bei der gewählten Lotwellentemperatur Lotmaterial auf die Baugruppenträgerunterseite aufbringt und zum Dampfphasenlöten neben der aus dem kondensierten Dampf kommenden Energie einen zusätzlichen Energiebetrag zuführt, so daß der Lötvorgang schneller erfolgt.

17. Verfahren nach einem der Ansprüche 1 bis 16,
**dadurch gekennzeichnet,**
**daß** das Wellen- und Dampfphasenlöten mit bleifreien Loten, deren Schmelztemperatur über der eutektischen Temperatur von Blei-Zinn-Lot und unterhalb der Lotwellentemperatur liegt, bei Lotwellentemperaturen durchgeführt wird, die bei alleinigem Wellenlöten für eutektisches Blei-Zinn-Lot verwendet werden und insbesondere zwischen ca. 240° C und 260° C liegen.

18. Vorrichtung zum Löten elektronischer Baugruppen bestehend aus einer Kammer (100, 200), welche zumindest in einem Teil des Kammervolumens von einem gesättigten Dampf einer Primärflüssigkeit erfüllt ist, und ferner einer Einrichtung zum Wellenlöten, welche sich zumindest teilweise innerhalb der Kammer (100, 200) befindet, sowie einer Einrichtung zum Transport einer elektronischen Baugruppe in die Kammer, durch die Kammer und aus der Kammer,
**dadurch gekennzeichnet,**
**daß** eine Einrichtung vorhanden ist, mit der das vom gesättigten Dampf erfüllte Kammervolumen variabel einstellbar ist, so daß sich nur ein Teil der elektronischen Baugruppe im gesättigten Dampf befindet.

19. Vorrichtung nach Anspruch 18,
**dadurch gekennzeichnet,**
**daß** die Vorrichtung eine oder mehrere Vorwärmeinrichtungen für eine oder mehrere elektronische Baugruppen enthält, wobei sich eine Vorwärmeinrichtung außerhalb der Kammer oder innerhalb der Kammer befindet.

20. Vorrichtung nach Anspruch 19,
**dadurch gekennzeichnet,**
**daß** als Vorwärmeinrichtung ein oder mehrere Infrarotstrahler und/oder Infrarotstrahlung (160) reflektierende Komponenten benutzt sind.

21. Vorrichtung nach einem der Ansprüche 19 oder 20,
**dadurch gekennzeichnet,**
**daß** eine oder mehrere Düsen (320a-g) in der Kammer (100, 200) angebracht sind, durch welche erhitzte Primärflüssigkeit auf eine elektronische Baugruppe zu deren Vorerwärmung aufbringbar ist.

22. Vorrichtung nach einem der Ansprüche 18 bis 21,
**dadurch gekennzeichnet,**
**daß** eine Kühl- und Abdampfeinrichtung für eine oder mehrere elektronische Baugruppen vorgesehen ist.

23. Vorrichtung nach einem der Ansprüche 18 bis 22,
**dadurch gekennzeichnet,**
**daß** die Vorrichtung ein Reservoir beinhaltet, das die Primärflüssigkeit enthält, welche durch eine Heizeinrichtung erhitzbar ist und welche mit ihrem gesättigten Dampf in Kontakt steht oder in Kontakt bringbar ist.

24. Vorrichtung nach Anspruch 23,
**dadurch gekennzeichnet,**
**daß** sich das Reservoir für die Primärflüssigkeit innerhalb der Kammer befindet oder daß sich das Reservoir außerhalb der Kammer befindet, wobei ein oder mehrere Leitungen für den gesättigten Dampf der Primärflüssigkeit vom Reservoir zur Kammer führen und der Dampfstrom mit einer Ventileinrichtung regulierbar ist und an einem Leitungsende an der Kammerwand Düsen angebracht sind.

25. Vorrichtung nach einem der Ansprüche 18 bis 24,
**dadurch gekennzeichnet,**
**daß** Kühleinrichtungen zur variablen Einstellung des vom Dampf erfüllten Kammervolumens verwendet und so ausgebildet sind, daß damit die Dampfdeckenhöhe variabel einstellbar ist.

26. Vorrichtung nach Anspruch 25,
**dadurch gekennzeichnet,**
**daß** Kühleinrichtungen an den Seitenwänden der Kammer mechanisch verschiebbar angebracht sind.

27. Vorrichtung nach einem der Ansprüche 25 oder 26,
**dadurch gekennzeichnet,**
**daß** als Kühleinrichtungen kühlende Rohrsysteme verwendet sind und/oder ein kühlendes Rohrsystem aus mehreren Teilrohrsystemen besteht, welche unabhängig voneinander kühlbar sind.

28. Vorrichtung nach einem der Ansprüche 25 bis 27,
**dadurch gekennzeichnet,**
**daß** als Kühleinrichtungen Kühlplatten (240a, 240b) in der Kammer vorgesehen sind, die in das vom Dampf erfüllte Kammervolumen einbringbar sind.

29. Vorrichtung nach Anspruch 28,
**dadurch gekennzeichnet,**
**daß** die Kühlplatten (240a, 240b) nahezu parallel zur Kammerdecke ausgerichtet und an der Kammerwand drehbar gelagert sind, so daß sie drehend in den Dampf einschwenkbar sind.

30. Vorrichtung nach einem der Ansprüche 25 bis 29,
**dadurch gekennzeichnet,**
**daß** auf die elektronische Baugruppe eine oder mehrere kühlende, geschlossen oder netzartig ausgebildete Abschirmeinrichtungen aufgesetzt sind.

31. Vorrichtung nach einem der Ansprüche 25 bis 30,
**dadurch gekennzeichnet,**
**daß** zum dosierten Einbringen von Primärflüssigkeit in die Kammer Düsensysteme, insbesondere an der Kammerdecke und/oder an den benachbarten Kammerwänden, vorgesehen sind.

32. Vorrichtung nach einem der Ansprüche 25 bis 31,
**dadurch gekennzeichnet,**
**daß** in der Kammer Einrichtungen zum Ableiten des an den Kühleinrichtungen kondensierten Dampfes, insbesondere zurück in das Primärflüssigkeitsreservoir, vorhanden sind.

33. Vorrichtung nach einem der Ansprüche 25 bis 32,
**dadurch gekennzeichnet,**
**daß** die Dampfdeckenhöhe zumindest im Bereich der zum Löten in die Kammer eingebrachten elektronischen Baugruppe nahezu als ebene Fläche ausgebildet und auf wenige Millimeter genau einstellbar und/oder regelbar ist.

34. Vorrichtung nach einem der Ansprüche 25 bis 33,
**dadurch gekennzeichnet,**
**daß** das nicht vom Dampf erfüllte Kammervolumen, insbesondere der Kammervolumenanteil über der Dampfdecke, mit einem Schutzgas, wie z. B. einem Edelgas oder Stickstoff, füllbar ist und dafür entsprechende Einbringöffnungen in der Kammer vorhanden sind.

35. Vorrichtung nach einem der Ansprüche 18 bis 34,
**dadurch gekennzeichnet,**
**daß** die Einrichtung zum Wellenlöten eine Lotwelle bereitstellt, die sich gänzlich im Dampf erstreckt, solange keine elektronische Baugruppe in den Dampf eingetaucht ist, und deren Höhe, die Scheitelpunktshöhe, unabhängig von der Lotwellentemperatur einstellbar ist.

36. Vorrichtung nach einem der Ansprüche 18 bis 35,
**dadurch gekennzeichnet,**
**daß** der gesättigte Dampf der Primärflüssigkeit als Oxidationsschutz für das Lot, wie z. B. für die Lotwelle und das Lotbad, in der Kammer dient.

37. Vorrichtung nach einem der Ansprüche 18 bis 36,
**dadurch gekennzeichnet,**
**daß** die Primärflüssigkeit als Oxidationsschutz für das Lotbad in der Abkühlphase dient, wobei insbesondere zu Primärflüssigkeit kondensierter Dampf mittels Ableiteinrichtungen zur Abdeckung auf die Oberfläche des Lotbades geleitet ist.

38. Vorrichtung nach einem der Ansprüche 18 bis 37,
**dadurch gekennzeichnet,**
**daß** die Einrichtung zum Wellenlöten eine elektrodynamische Lotpumpe zum Bereitstellen der Lotwelle enthält.

39. Vorrichtung nach einem der Ansprüche 18 bis 38,
**dadurch gekennzeichnet,**
**daß** die Einrichtung zum Transport einer elektronischen Baugruppe so ausgebildet ist, daß die Baugruppe mit der Lotwelle in Kontakt bringbar ist, und daß der Lötwinkel zwischen 0° C und 10° C einstellbar ist.

40. Vorrichtung nach einem der Ansprüche 18 bis 39,
**dadurch gekennzeichnet,**
**daß** eine Einrichtung zum Erkennen einer elektronischen Baugruppe und/oder der Art der zu lötenden Bauelemente vorgesehen ist und eine Steuereinheit abhängig von den mit der Erkennungseinrichtung ermittelten Daten für die Einstellung und Überwachung relevanter Lötparameter sorgt.

## Claims

1. Method for soldering electronic units using vapour-phase soldering or a combination of wave soldering and vapour-phase soldering, it being possible for the wave soldering and the vapour-phase soldering to be carried out in a single chamber (100, 200),
**characterised in that**
an electronic unit having mixed fittings including heat-sensitive components, especially electrolytic capacitors and components containing plasti cs materials which are not temperature-stable, is so disposed and the proportion of the volume of the chamber (100; 200) filled with the saturated vapour of a primary fluid is so regulated that the heat-sensitive components (152, 153) of the unit are at the most partially located in the saturated vapour, and that the connections to be soldered of the components (152, 153) of the electronic unit are located in the saturated vapour during soldering.

2. Method according to claim 1,
**characterised in that**,
to regulate the vapour volume, the height of the saturated vapour in the chamber (vapour blanket) is set to a specific value and/or regulated to this height value.

3. Method according to claim 2,
**characterised in that**
cooling devices are used to alter and set the height of the vapour blanket (124; 224).

4. Method according to claim 3,
**characterised in that**,
as the cooling devices (230a, 230b), cooling pipe systems (130a, 130b) in a specific arrangement and geometrical configuration are used, and/or cooling plates (240a, 240b) can be introduced into the volume filled by the vapour, in particular can be rotatably swivelled in, and/or cooling shielding devices, configured closed or in a network, can be applied to the unit.

5. Method according to one of claims 2 to 4,
**characterised in that**,
to alter and set the vapour blanket height, a fluid, especially the primary fluid, is introduced into the vapour volume, the temperature of the fluid being lower than the temperature of the vapour.

6. Method according to claim 5,
**characterised in that**
the primary fluid is injected into the chamber via nozzle systems, especially one or more nozzles (320a-g).

7. Method according to one of claims 2 to 6,
**characterised in that**,
to alter and set the vapour blanket height (124, 224), the apertures, especially one or more nozzles, through which the vapour flows into the chamber volume filled by same, are at least partially closed.

8. Method according to claim 7,
**characterised in that**
the remaining chamber volume is simultaneously filled with a protective gas, especially a noble gas or nitrogen.

9. Method according to one of claims 1 to 8,
**characterised in that**
the wave soldering and the vapour-phase soldering are carried out in a single method step.

10. Method according to one of claims 1 to 9,
**characterised in that**
an electronic unit (250) is pre-heated before the soldering.

11. Method according to claim 10,
**characterised in that**
infrared radiation (160) is used as the energy source for the pre-heating, and **in that** the pre-heating takes place outside and/or inside the chamber.

12. Method according to one of claims 10 or 11,
**characterised in that**
heated primary fluid is applied to the electronic unit (250) in order to preheat the unit.

13. Method according to one of claims 10 to 12,
**characterised in that**
a saturated vapour filling at least a portion of the chamber volume is used to pre-heat the electronic unit.

14. Method according to one of claims 1 to 13,
**characterised in that**
the temperatures on the sub-rack upper and lower sides can be set to various values by differing choice of the boiling temperature of the primary fluid and the solder wave temperature.

15. Method according to one of claims 1 to 14,
**characterised in that**
the soldering temperature is selected to be slightly higher than the melting temperature of the solder, and/or **in that** a primary fluid is used, the boiling temperature of which is equal to or slightly higher than the solder temperature.

16. Method according to one of claims 1 to 5,
**characterised in that**
the solder wave (212) applies solder material to the sub-rack underside at the selected solder wave temperature and supplies for vapour-phase soldering, as well as the energy coming from the condensed vapour, an additional amount of energy such that the soldering process takes place more rapidly.

17. Method according to one of claims 1 to 16,
**characterised in that**
the wave and vapour-phase soldering is carried out with lead-free solders, the melting temperature of which lies above the eutectic temperature of lead-tin solder and below the solder wave temperature, at solder wave temperatures which are used for eutectic lead-tin solder in wave soldering on its own, and are especially between approximately 240°C and 260°C.

18. Device for soldering electronic units comprising a chamber (100, 200) which is filled at least in a portion of its volume by a saturated vapour of a primary fluid, and in addition a device for wave soldering which is located at least partially insider the chamber (100, 200), as well as a device for conveying an electronic unit into the chamber, through the chamber and out of the chamber,
**characterised in that**
a device is present by means of which the chamber volume filled by the saturated vapour can be set in a variable manner, such that only a portion of the electronic unit is located in the saturated vapour.

19. Device according to claim 18,
**characterised in that**
the device contains one or more pre-heating devices for one or more electronic units, a pre-heating device being located outside the chamber or inside the chamber.

20. Device according to claim 19,
**characterised in that**
one or more infrared radiators and/or components reflecting infrared radiation (160) are used as pre-heating devices.

21. Device according to one of claims 19 or 20,
**characterised in that**
there are attached in the chamber (100, 200) one or more nozzles (320a-g) through which heated primary fluid can be applied to an electronic unit in order to pre-heat same.

22. Device according to one of claims 18 to 21,
**characterised in that**
one cooling and evaporating device is provided for one or more electronic units.

23. Device according to one of claims 18 to 22,
**characterised in that**
the device includes a reservoir which contains the primary fluid which can be heated by a heating device and which is in contact with or can be brought into contact with its saturated vapour.

24. Device according to claim 23,
**characterised in that**
the reservoir for the primary fluid is located inside the chamber or **in that** the reservoir is located outside the chamber, one or more lines for the saturated vapour of the primary fluid leading from the reservoir to the chamber, and it being possible to regulate the flow of vapour by means of a valve device and nozzles being attached to the chamber wall at one end of the line.

25. Device according to one of claims 18 to 24,
**characterised in that**
the cooling devices are used to set in a variable manner the chamber volume filled by the vapour and are so configured, that the height of the vapour blanket can be set by them in a variable manner.

26. Device according to claim 25,
**characterised in that**
cooling devices are attached on the side walls of the chamber so as to be mechanically displaceable.

27. Device according to one of claims 25 or 26,
**characterised in that**
that cooling pipe systems are used as cooling devices, and/or a cooling pipe system comprises a plurality of partial pipe systems which can be cooled independently of one another.

28. Device according to one of claims 25 to 27,
**characterised in that**
as cooling devices, cooling plates (240a, 240b) are provided in the chamber which can be introduced into the chamber volume filled by the vapour.

29. Device according to claim 28,
**characterised in that**
the cooling plates (240a, 240b) are aligned practically parallel to the chamber ceiling and are rotatably mounted on the chamber wall so that they can be swivelled rotating into the vapour.

30. Device according to one of claims 25 to 29,
**characterised in that**
one or more cooling shielding devices, configured closed or in a network, are placed on the electronic unit.

31. Device according to one of claims 25 to 30,
**characterised in that**
nozzle systems are provided, especially on the chamber ceiling and/or on the adjacent chamber walls, for the metered introduction of primary fluid into the chamber.

32. Device according to one of claims 25 to 31,
**characterised in that**
devices for taking away the vapour condensed on the cooling devices, particularly back into the primary fluid reservoir, are provided in the chamber.

33. Device according to one of claims 25 to 32,
**characterised in that**
the vapour blanket height, at least in the region of the electronic unit introduced into the chamber for soldering, is configured as a flat surfa ce and can be adjusted and/or regulated accurate to a few millimetres.

34. Device according to one of claims 25 to 33,
**characterised in that**
the chamber volume not filled by the vapour, especially the proportion of the chamber volume above the vapour blanket, can be filled with a protective gas, such as e.g. a noble gas or nitrogen, and corresponding feed apertures are present in the chamber for this purpose.

35. Device according to one of claims 18 to 34,
**characterised in that**
the device for wave soldering makes available a solder wave which extends completely in the vapour as long as no electronic unit is immersed in the vapour, and the height of which, the summit height, can be set independently of the solder wave temperature.

36. Device according to one of claims 18 to 35,
**characterised in that**
the saturated vapour of the primary fluid serves as protection against oxidation for the solder in the chamber, as e.g. for the solder wave and the solder bath.

37. Device according to one of claims 18 to 36,
**characterised in that**
the primary fluid serves as protection against oxidation for the solder bath in the cooling phase, in particular vapour condensed into primary fluid being led by means of discharge devices to form a cover on the surface of the solder bath.

38. Device according to one of claims 18 to 37,
**characterised in that**
the device for wave soldering contains an electrodynamic solder pump to prepare the solder wave.

39. Device according to one of claims 18 to 38,
**characterised in that**
the device for conveying an electronic unit is so configured that the unit can be brought into contact with the solder wave, and that the soldering angle can be set between 0°C and 10°C.

40. Device according to one of claims 18 to 39,
**characterised in that**
a device for recognising an electronic unit and/or the type of components to be soldered is provided and a control unit sees to setting and monitoring relevant soldering parameters in dependence on the data obtained by means of the detection device.

## Revendications

1. Procédé de brasage de composants électroniques en utilisant le brasage en phase vapeur ou une combinaison de brasage à la vague et de brasage en phase vapeur, le brasage à la vague et le brasage en phase vapeur étant effectués dans une unique chambre (100, 200)
**caractérisé en ce qu'**
un groupe de composants électroniques mélangés, comprenant des composants sensibles à la température notamment des condensateurs à électrolyte et des composants comportant des matières synthétiques non stables en température, est placé de manière telle et le volume partiel de la chambre (100, 200) rempli par la vapeur saturée du fluide primaire est régulée de façon telle que les composants sensibles à la température (152, 153) du groupe de composants se trouvent au plus en partie dans la vapeur saturée et que les broches à braser des composants (152, 153) du groupe de composants électroniques, se trouvent dans la vapeur saturée pendant le brasage.

2. Procédé selon la revendication 1,
**caractérisé en ce que**
pour réguler le volume de vapeur on régule la hauteur de vapeur saturée dans la chambre (plafond de vapeur) à une valeur déterminée et/ou on la régule à cette valeur,

3. Procédé selon la revendication 2,
**caractérisé en ce qu'**
on utilise des installations de refroidissement pour modifier et régler la hauteur du plafond de vapeur (124, 224).

4. Procédé selon la revendication 3,
**caractérisé en ce que**
les installations de refroidissement (230a, 230b) sont des systèmes de tuyaux (130a, 130b) répartis d'une manière déterminée et ayant une réalisation géométrique définie et/ou des plaques de refroidissement (240a, 240b) qui viennent dans le volume rempli par la vapeur en pouvant notamment y basculer et/ou des installations de refroidissement sous forme d'écran plein ou de grille, que l'on place sur les composants.

5. Procédé selon l'une quelconque des revendications 2 à 4,
**caractérisé en ce que**
pour modifier et régler la hauteur du plafond de vapeur, on introduit un liquide notamment le fluide primaire dans le volume de vapeur, la température du fluide étant inférieure à la température du bain.

6. Procédé selon la revendication 5,
**caractérisé en ce qu'**
on pulvérise le fluide primaire par un système de buses notamment une ou plusieurs buses (320a-g) dans la chambre.

7. Procédé selon l'une quelconque des revendications 2 à 6,
**caractérisé en ce que**
pour modifier et régler la hauteur du plafond de vapeur (124, 224) on ferme au moins en partie les ouvertures, notamment une ou plusieurs buses, à travers lesquelles la vapeur s'écoule dans le volume de la chambre rempli par la vapeur.

8. Procédé selon la revendication 7,
**caractérisé en ce qu'**
on remplit le volume résiduel de la chambre en même temps avec un gaz protecteur, notamment un gaz rare ou de l'azote.

9. Procédé selon l'une quelconque des revendications 1 à 8,
**caractérisé en ce qu'**
on effectue le brasage à la vague et le brasage en phase vapeur au cours d'une unique étape de procédé.

10. Procédé selon l'une quelconque des revendications 1 à 9
**caractérisé en ce qu'**
on préchauffe un groupe de composants électroniques (250) avant de braser.

11. Procédé selon la revendication 10.
**caractérisé en ce qu'**
on utilise comme porteur d'énergie de préchauffage un rayonnement infrarouge (160) et on effectue le préchauffage en dehors de la chambre et/ou à l'intérieur de la chambre.

12. Procédé selon l'une quelconque des revendications 10 ou 11,
**caractérisé en ce que**
pour le préchauffage du groupe de composants électroniques (250), on applique un fluide primaire préchauffé sur le groupe de composants.

13. Procédé selon l'une quelconque des revendications 10 à 12,
**caractérisé en ce que**
pour le préchauffage du groupe de composants électroniques, on utilise au moins une partie du volume de la chambre rempli de vapeur saturée.

14. Procédé selon l'une quelconque des revendications 1 à 13,
**caractérisé en ce qu'**
on règle à des niveaux différents les températures du côté supérieur du support de groupe de composants, et du côté inférieur du support de groupe de composants par un choix différent de la température d'ébullition du fluide primaire et de la température de la vague de brasure.

15. Procédé selon l'une quelconque des revendications 1 à 14,
**caractérisé en ce qu'**
on choisit comme température de brasure une température légèrement supérieure à la température de fusion de la brasure, et/ou on utilise un fluide primaire dont la température d'ébullition est égale ou légèrement supérieure à la température de brasure.

16. Procédé selon l'une quelconque des revendications 1 à 15,
**caractérisé en ce que**
la vague de brasure (212), pour une température choisle pour la vague de brasure, applique de la brasure sur la face inférieure du support de composants et pour le brasage en phase vapeur, à côté de l'énergie provenant de la vapeur condensée, elle fournit une partie supplémentaire d'énergie pour que l'opération de brasage se déroule plus rapidement.

17. Procédé selon l'une quelconque des revendications 1 à 16,
**caractérisé en ce que**
le brasage à la vague et le brasage en phase vapeur se font avec de la brasure sans plomb dont la température de fusion est supérieure à la température eutectique de la brasure plomb-étain et inférieure à la température de la vague de brasure, ces brasages étant effectués à des températures de vague de brasure utilisées pour le seul brasage à la vague avec une brasure eutectique plomb-étain, et notamment comprises entre environ 240°C et 260°C.

18. Dispositif pour braser des groupes de composants électroniques, comprenant
une chambre (100, 200) dont au moins une partie du volume est remplie par de la vapeur saturée d'un fluide primaire, et une installation de brasage à la vague qui se trouve au moins partiellement dans la chambre (100, 200), ainsi qu'une installation pour transporter un groupe de composants électroniques dans la chambre, à travers la chambre et l'évacuer de la chambre,
**caractérisé par**
une installation permettant de régler de manière variable le volume de la chambre rempli de vapeur saturée pour que seulement une partie du groupe de composants électroniques se trouve dans la vapeur saturée.

19. Dispositif selon la revendication 18,
**caractérisé en ce qu'**
il comporte une ou plusieurs installations de préchauffage pour un ou plusieurs groupes de composants électroniques, une installation de préchauffage étant prévue à l'extérieur de la chambre ou à l'intérieur de la chambre.

20. Dispositif selon la revendication 19.
**caractérisé en ce que**
l'installation de préchauffage est formée par un ou plusieurs éléments à rayonnement infrarouge et/ou composants réfléchissant un rayonnement infrarouge (160).

21. Dispositif selon l'une quelconque des revendications 19 ou 20,
**caractérisé par**
une ou plusieurs buses (320a-g) prévues dans la chambre (100, 200) par lesquelles du liquide primaire réchauffé est appliqué à un groupe de composants électroniques pour le préchauffer.

22. Dispositif selon l'une quelconque des revendications 18 à 21,
**caractérisé par**
une installation de refroidissement et de dégagement de vapeur pour un ou plusieurs groupes de composants électroniques.

23. Dispositif selon l'une quelconque des revendications 18 à 22
**caractérisé en ce que**
le dispositif comporte un réservoir qui contient le fluide primaire chauffé par une installation de chauffage et qui est en contact ou peut être mis en contact avec sa vapeur saturée.

24. Dispositif selon la revendication 23.
**caractérisé en ce que**
le réservoir de fluide primaire se trouve dans la chambre, ou le réservoir se trouve à l'extérieur de la chambre avec une ou plusieurs conduites de vapeur saturée de fluide primaire reliant le réservoir à la chambre, et le débit de vapeur est régulé par une installation à vannes, l'extrémité des conduites comportant des buses au niveau de la paroi de la chambre.

25. Dispositif selon l'une quelconque des revendications 18 à 24.
**caractérisé en ce que**
les installations de refroidissement sont utilisées pour le réglage variable du volume de la chambre rempli par la vapeur et ces installations sont réalisées pour permettre de régler de manière variable la hauteur du plafond de vapeur.

26. Dispositif selon la revendication 25,
**caractérisé en ce que**
les installations de refroidissement sont prévues sur les parois latérales de la chambre et peuvent être coulissées mécaniquement.

27. Dispositif selon l'une quelconque des revendications 25 ou 26,
**caractérisé en ce que**
les installations de refroidissement sont des systèmes de tuyaux de refroidissement et/ou un système tubulaire de refroidissement formé de plusieurs systèmes partiels de tuyaux qui peuvent être refroidis indépendamment les uns des autres.

28. Dispositif selon l'une quelconque des revendications 25 à 27,
**caractérisé en ce que**
les installations de refroidissement sont des plaques de refroidissement (240a, 240b) prévues dans la chambre et qui se placent dans le volume de la chambre rempli par la vapeur.

29. Dispositif selon la revendication 28,
**caractérisé en ce que**
les plaques de refroidissement (240a, 240b) sont alignées pratiquement parallèlement au plafond de la chambre et peuvent être pivotées sur la paroi de la chambre pour basculer par pivotement dans la vapeur.

30. Dispositif selon l'une quelconque des revendications 25 à 29,
**caractérisé par**
une ou plusieurs installations formant écran de refroidissement, fermé ou en forme de réseau, qui se place sur les composants électroniques.

31. Dispositif selon l'une quelconque des revendications 25 à 30,
**caractérisé en ce que**
notamment le plafond de la chambre et/ou les parois voisines de la chambre comportent des systèmes de buses pour introduire de manière dosée du fluide primaire dans la chambre.

32. Dispositif selon l'une quelconque des revendications 25 à 31,
**caractérisé en ce que**
la chambre comporte des installations pour évacuer la vapeur condensée sur les installations de refroidissement et notamment la reconduire dans le réservoir de fluide primaire.

33. Dispositif selon l'une quelconque des revendications 25 à 32,
**caractérisé en ce que**
la hauteur du plafond de vapeur au moins dans la zone des groupes de composants électroniques introduits dans la chambre pour être brasés, est une surface plane et se règle et/ou se régule de manière précise à quelques millimètres près.

34. Dispositif selon l'une quelconque des revendications 25 à 33,
**caractérisé en ce que**
le volume de la chambre non rempli par la vapeur notamment la partie de volume de la chambre au-dessus du plafond de vapeur est rempli d'un gaz protecteur comme par exemple un gaz rare ou de l'azote et la chambre comporte des orifices d'entrée pour ce remplissage.

35. Dispositif selon l'une quelconque des revendications 18 à 34,
**caractérisé en ce que**
l'installation de brasage à la vague réalise une vague de brasure qui s'étend complètement dans la vapeur aussi longtemps qu'aucun composant électronique ne plonge dans la vapeur et la hauteur de la vague c'est-à-dire la hauteur du sommet de la vague se règle indépendamment de la température de la vague de brasure.

36. Dispositif selon l'une quelconque des revendications 18 à 35,
**caractérisé en ce que**
la vapeur saturée de fluide primaire constitue un moyen de protection contre l'oxydation de la brasure comme par exemple pour la vague de brasure ou le bain de brasure dans la chambre.

37. Dispositif selon l'une quelconque des revendications 18 à 36,
**caractérisé en ce que**
le liquide primaire est un moyen de protection contre l'oxydation du bain de brasure en phase de refroidissement et en particulier de la vapeur de fluide primaire condensée, avec des installations d'évacuation pour recouvrir la surface du bain de brasure.

38. Dispositif selon l'une quelconque des revendications 18 à 37.
**caractérisé en ce que**
l'installation de brasage à la vague comporte une pompe à brasure électrodynamique pour réaliser la vague de brasure.

39. Dispositif selon l'une quelconque des revendications 18 à 38.
**caractérisé en ce que**
l'installation de transport d'un composant électronique est réalisée pour que le groupe de composants puisse être mis en contact avec la vague de brasure et on règle l'angle de brasage à une valeur comprise entre 0° et 10°.

40. Dispositif selon l'une quelconque des revendications 18 à 39,
**caractérisé par**
une installation pour détecter un composant électronique et/ou la nature du composant à braser et une installation de commande qui règle et surveille les paramètres caractéristiques du brasage en fonction des données fournies par l'installation de détection.
